(19) Europäisches Patentamt / European Patent Office / Office européen des brevets

(11) **EP 3 020 750 B1**

(12) **EUROPEAN PATENT SPECIFICATION**

(45) Date of publication and mention of the grant of the patent: **03.09.2025 Bulletin 2025/36**

(21) Application number: **14822899.2**

(22) Date of filing: **04.07.2014**

(51) International Patent Classification (IPC):
***C08G 77/14*** *(2006.01)* ***C08G 59/02*** *(2006.01)*
***C08G 77/20*** *(2006.01)* ***C08L 83/05*** *(2006.01)*
***C08L 83/06*** *(2006.01)* ***C08L 83/07*** *(2006.01)*
***C08L 83/04*** *(2006.01)*

(52) Cooperative Patent Classification (CPC):
(C-Sets available)
**C08L 83/06; C08K 5/56; C08L 83/00; C08L 83/04; H10H 20/854;** C08G 77/12; C08G 77/14; C08G 77/20; H10H 20/8511 (Cont.)

(86) International application number: **PCT/JP2014/067969**

(87) International publication number: **WO 2015/005247 (15.01.2015 Gazette 2015/02)**

# (54) ADHESIVENESS-IMPARTING AGENT, ADHESIVE POLYORGANOSILOXANE COMPOSITION, AND OPTICAL SEMICONDUCTOR DEVICE

HAFTVERLEIHENDES MITTEL, HAFTENDE POLYORGANOSILOXANZUSAMMENSETZUNG UND OPTISCHES HALBLEITERBAUELEMENT

AGENT CONFÉRANT DE L'ADHÉSIVITÉ, COMPOSITION DE POLYORGANOSILOXANE ADHÉSIVE, ET DISPOSITIF SEMI-CONDUCTEUR OPTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.07.2013 JP 2013142751**
**21.02.2014 JP 2014031754**

(43) Date of publication of application: **18.05.2016 Bulletin 2016/20**

(73) Proprietor: **Momentive Performance Materials Japan LLC**
**Tokyo 107-6112 (JP)**

(72) Inventors:
- **OTAKE Tatsuya**
  **Tokyo 107-6112 (JP)**
- **TAKAGI Akira**
  **Tokyo 107-6112 (JP)**
- **MOCHIZUKI Kikuo**
  **Tokyo 107-6112 (JP)**

(74) Representative: **Marks & Clerk LLP**
**15 Fetter Lane**
**London EC4A 1BW (GB)**

(56) References cited:

| | |
|---|---|
| **EP-A1- 3 103 843** | **WO-A1-2015/030224** |
| **JP-A- 2007 327 019** | **JP-A- 2010 001 335** |
| **JP-A- 2011 208 120** | **JP-A- 2012 052 045** |
| **JP-A- 2012 251 166** | **JP-A- H09 310 024** |
| **JP-A- S6 470 559** | **JP-A- S6 485 224** |
| **US-A1- 2009 118 440** | **US-A1- 2009 294 796** |

- **DATABASE WPI Week 199807, Derwent World Patents Index; AN 1998-071974, XP002765283**
- **"Silicones", 15 April 2003, ENCYCLOPEDIA OF POLYMER SCIENCE AND TECHNOLOGY, WILEY, US, PAGE(S) 765 - 841, XP007918236**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08L 83/04, C08L 83/00, C08L 83/00, C08K 5/56**

## Description

### FIELD

The present invention relates to an adhesiveness imparting agent, an adhesive polyorganosiloxane composition, and an optical semiconductor device, and in particular to an adhesiveness imparting agent giving, to a material mainly containing polyorganosiloxane, excellent adhesiveness to heat-resistant plastic such as a polyphthalamide resin (hereinafter, referred to as PPA), an adhesive polyorganosiloxane composition excellent in adhesiveness to the heat-resistant plastic and the like, and an optical semiconductor device having a cured product of the composition as a sealant or the like.

### BACKGROUND

A silicone (polyorganosiloxane) composition such as silicone rubber or silicone gel forms a cured product excellent in various characteristics such as weather resistance, heat resistance, hardness, elongation and so on, and therefore is used for various applications.

For example, in an LED device including a light emitting element such as a light emitting diode (LED), a polyorganosiloxane composition excellent in heat resistance, ultraviolet resistance characteristics and so on is used as a material that seals the light emitting element and a material that forms a lens to be disposed in an optical path from the light emitting element. In particular, an addition reaction type polyorganosiloxane composition cured by hydrosilylation is cured in a short time by heating and produces no bi-product when curing, and is therefore widely used as a sealant or the like for the LED device.

However, a conventional addition reaction type polyorganosiloxane composition is low in adhesiveness and, in particular, insufficient in adhesiveness to noble metals such as silver (Ag), gold (Au) and the like used as a frame and electrodes of the LED device and to heat-resistant plastic such as PPA and the like used as a reflector and a support substrate. Therefore, it is performed to add a silane compound having an epoxy group such as γ-glycidoxypropylmethyldimethoxysilane or γ-glycidoxypropyltrimethoxysilane to an addition reaction type polyorganosiloxane composition so as to improve adhesiveness (for example, refer to Patent Reference 1).

However, the silane compound has a low molecular weight and is likely to volatilize, and therefore evaporates due to heating in a process of forming a sealing layer or the like by molding and curing the polyorganosiloxane composition. Further, even after the formation of the sealing layer, the silane compound is likely to volatilize due to heat generation from the light emitting element, heating in application of the temperature cycle and so on, and to be lost from the sealing layer. Therefore, the adhesiveness of the sealing layer decreases, and peeling occurs between the base material such as PPA or the like and the sealing layer.

Further, there is also proposed a polyorganosiloxane composition for the LED device containing, as an adhesiveness imparting component, a silane coupling agent, a siloxane having a hydrosilyl group and/or an alkoxysilyl group, and an organofunctional group such as a (meth)acryloxy group or an epoxy group (for example, refer to Patent Reference 2). However, this composition is also insufficient in long-term adhesiveness to PPA or the like.

Also Patent Reference 3 discloses an adhesiveness imparting agent comprising a polyorganosiloxane containing a siloxane T unit presenting an alkyl glycidoxy group and a siloxane D unit presenting an alkenyl group; and a curable composition for a LED device comprising this agent.

### RELEVANT REFERECNES

#### Patent References

Patent Reference 1: JP-A 2010-248384
Patent Reference 2: JP-A 2009-269968
Patent Reference 3: JP-A H09 310024

### DISCLOSUE OF THE INVENTION

### PROBLEMS TO BE SOLVED BY THE INVENTION

The present invention has been made to solve such problems in the prior art and an object is to provide an adhesiveness imparting agent to be compounded to improve adhesiveness to heat-resistant plastic such as PPA in a composition of a polyorganosiloxane or the like. Another object is to provide an adhesive polyorganosiloxane composition

having excellent adhesiveness to the heat-resistant plastic or the like and never decreasing in adhesiveness due to heat generation from a light emitting element, and heating in a temperature cycle or the like, and suitable as a sealant or the like for an optical semiconductor device.

MEANS FOR SOLVING THE PROBLEMS

An adhesiveness imparting agent of the present invention comprises a polyorganosiloxane, the polyorganosiloxane containing: (a) at least one kind of siloxane unit having an epoxy group selected from a group consisting of a trifunctional siloxane unit represented by a formula: $R^1SiO_{3/2}$ (in the formula, $R^1$ representing an epoxyalkyl group or a glycidoxyalkyl group;

(b) a bifunctional siloxane unit having an alkenyl group represented by a formula: $R^3{}_2SiO_{2/2}$ (in the formula, $R^3$ representing a monovalent hydrocarbon group selected from a group consisting of an alkenyl group and an alkyl group, and at least one $R^3$ is an alkenyl group;
trifunctional siloxane unit represented by a formula $R^4SiO_{3/2}$, where $R^4$ represents an alkyl group; and a bifunctional siloxane unit represented by a formula $R^4{}_2SiO_{2/2}$, where $R^4$ represents an alkyl group, the polyorganosiloxane having a weight-average molecular weight of 1000 to 15000.

Further, an adhesive polyorganosiloxane composition of the present invention comprises: (A) 100 parts by mass of a polyorganosiloxane having an alkenyl group bonded to a silicon atom; (B) a polyorganohydrogensiloxane having a hydrogen atom bonded to a silicon atom in such an amount that an amount of the hydrogen atom in the component becomes 0.1 to 4.0 per alkenyl group in the (A) component; (C) a catalytic amount of a platinum-based catalyst; and (D) 0.05 to 10 parts by mass of the adhesiveness imparting agent of the present invention.
An optical semiconductor device of the present invention comprises a cured product made by curing the adhesive polyorganosiloxane composition of the present invention.
Note that in the following description, an "alkenyl group bonded to a silicon atom" is sometimes referred to as an "alkenyl group." Further, a "hydrogen atom bonded to a silicon atom" is sometimes referred to as a "hydrogen atom."

EFFECT OF THE INVENTION

The adhesiveness imparting agent of the present invention, when compounded in the polyorganosiloxane composition or the like, can improve adhesiveness to the heat-resistant plastic such as PPA. Further, the adhesiveness imparting agent never volatilizes to be lost from the compounded composition due to heating when curing, heat generation from the light emitting element after the curing, heating in a temperature cycle, or the like, and therefore never decreases in adhesiveness.
Further, the adhesive polyorganosiloxane composition of the present invention has excellent adhesiveness to the heat-resistant plastic such as PPA and the excellent adhesiveness never decreases due to a temperature increase caused from heat generation or application of a temperature cycle or the like. Accordingly, the optical semiconductor device such as an LED device, in which the sealing layer is formed of the cured product of the polyorganosiloxane composition, is excellent in adhesiveness between the sealing layer and a plastic base material so that peeling hardly occurs at the boundary face between them, and is high in reliability.

BRIEF DESCRIPTION OF THE DRAWING

Fig. 1 is a graph illustrating a profile of an increased temperature for investigating adhesiveness in a package test (1) for polyorganosiloxane compositions obtained in Examples 1 to 6 and Comparative Examples 1, 2.

DETAILED DESCRIPTION

Hereinafter, embodiments of the present invention will be described.

[Adhesiveness imparting agent]

A first embodiment of the present invention is an adhesiveness imparting agent including a polyorganosiloxane containing (a) a siloxane unit having an epoxy group; (b) a bifunctional siloxane unit having an alkenyl group; a trifunctional siloxane unit represented by a formula $R^4SiO_{3/2}$, where $R^4$ represents an alkyl group; and a bifunctional siloxane unit represented by a formula $R^4{}_2SiO_{2/2}$, where $R^4$ represents an alkyl group; in which a weight-average molecular weight (hereinafter, referred to as Mw) is 1000 to 15000.

Here, the (a) siloxane unit having an epoxy group is a trifunctional siloxane unit represented by a formula (1): $R^1SiO_{3/2}$, where $R^1$ represents an epoxyalkyl group or a glycidoxyalkyl group.

The (b) bifunctional siloxane unit having an alkenyl group is a unit represented by a formula (4): $R^3{}_2SiO_{2/2}$. Note that in the formula (4), $R^3$ represents a monovalent hydrocarbon group selected from a group consisting of an alkenyl group and an alkyl group, and at least one of the two $R^3$ is an alkenyl group.

The polyorganosiloxane as claimed containing the (a) siloxane unit having an epoxy group and the (b) bifunctional siloxane unit having an alkenyl group, and having an Mw in the above-describe range, when compounded into an addition reaction type polyorganosiloxane composition containing a polyorganosiloxane having an alkenyl group in a molecule as a base polymer and a polyorganohydrogensiloxane having a hydrogen atom in a molecule, is excellent in compatibility with the base polymer and uniformly mixed, in which the alkenyl group in the bifunctional siloxane unit reacts with the hydrogen atom of the polyorganohydrogensiloxane contained in the composition when the composition is cured, and is combined to the base polymer through the reaction. Therefore, the polyorganosiloxane in the first embodiment is never lost due to volatilization by heat generation when heat curing the composition and after the curing, heating in a temperature cycle or the like, and therefore exhibits high adhesiveness derived from the epoxy group with respect to noble metals such as gold and silver and plastics such as PPA.

Hereinafter, the siloxane units constituting the polyorganosiloxane being the adhesiveness imparting agent in the first embodiment will be further described.

<(a) Siloxane unit having an epoxy group>

The (a) siloxane unit having an epoxy group is at least one kind of siloxane unit selected from a group consisting of the trifunctional siloxane unit (hereinafter, referred to as a $T1^{ep}$ unit) represented by the formula (1): $R^1SiO_{3/2}$, as claimed.

$R^1$ represents an epoxyalkyl group, or a glycidoxyalkyl group. From the view point of easiness to synthesize the polyorganosiloxane being the adhesiveness imparting agent, $R^1$ is preferably a glycidoxyalkyl group, and particularly preferably $\gamma$-glycidoxypropyl group.

The (a) siloxane unit having an epoxy group includes at least the $T1^{ep}$ unit so that the adhesiveness imparting agent to be obtained (polyorganosiloxane) is less likely to volatilize.

<(b) Bifunctional siloxane unit having an alkenyl group>

The (b) bifunctional siloxane unit having an alkenyl group is a unit represented by the formula (4): $R^3{}_2SiO_{2/2}$. Note that in the formula (4), $R^3$ represents a monovalent hydrocarbon group selected from an alkenyl group and an alkyl group , and at least one of the two $R^3$ is an alkenyl group. Examples of the alkenyl group include a vinyl group, an allyl group, a butenyl group, a pentenyl group, a hexenyl group and so on, and the vinyl group is more preferable. The group other than the alkenyl group in $R^3$ is preferably an alkyl group, and particularly preferably a methyl group. Hereinafter, the bifunctional siloxane unit having an alkenyl group represented by the formula (4) is referred to as a $D1^{vi}$ unit.

<Other siloxane units>

The polyorganosiloxane being the adhesiveness imparting agent contains the (a) $T1^{ep}$ unit and the (b) $D1^{vi}$ unit, and further contains a trifunctional siloxane unit represented by a formula (5): $R^4SiO_{3/2}$ and a bifunctional siloxane unit represented by a formula (6): $R^4{}_2SiO_{2/2}$.

In the formulas (5) and (6), $R^4$ represents an alkyl group. $R^4$ is preferably a methyl group. Hereinafter, the trifunctional siloxane unit represented by the formula (5) is referred to as a T1 unit, and the bifunctional siloxane unit represented by the formula (6) is referred to as a D1 unit.

In the polyorganosiloxane being the adhesiveness imparting agent, the composition ratio of the siloxane units, namely, the molar ratio with a unit having a epoxy group, the unit being at least one kind selected from the (a) $T1^{ep}$ unit (hereinafter, referred to as a $T1^{ep}$ unit, the (b) $D1^{vi}$ unit, and the other units (the T1 unit and the D1 unit) is not particularly limited, but the ratio of the (a) $T1^{ep}$ unit is preferably set to 5 to 50 mol% of all units from the viewpoint of imparting adhesiveness to a polyorganosiloxane composition. Further, the ratio of the (b) $D1^{vi}$ unit is preferably set to 1 to 40 mol% of all units from the viewpoint of reactivity to the addition reaction type polyorganosiloxane composition.

<Preparation method>

The adhesiveness imparting agent in the first embodiment can be prepared, for example, by the following method.

Specifically, at least one kind of silane compound having an epoxy group, selected from a trifunctional silane represented by a formula: $R^1Si(OR^2)_3$, a silane compound having an alkenyl group represented by a formula: $R^3{}_2Si(OR^2)$,

a trifunctional silane represented by a formula: $R^4Si(OR^2)_3$ and a bifunctional silane represented by a formula: $R^4{}_2Si(OR^2)_2$ are charged into a reaction container, the liquid is made basic and heated, and subjected to partial hydrolysis and then condensation reaction.

In the above formula, $R^1$ represents a monovalent organic group having an epoxy as claimed, $R^3$ represents a monovalent hydrocarbon group selected from an alkenyl and an alkyl group, and $R^4$ represents an alkyl group, As those groups, the same groups as described above can be exemplified. Preferable groups are also the same as described above.

Then, alcohol is distilled off from the obtained reaction mixture, and then the liquid is neutralized. Thereafter, a low-molecular weight component is removed from the reaction mixture, and solvent removal and concentration are performed, whereby the polyorganosiloxane being the adhesiveness imparting agent in the first embodiment can be obtained.

The Mw of the polyorganosiloxane thus obtained is set to a range of 1000 to 15000. When the Mw of the polyorganosiloxane is less than 1000, the polyorganosiloxane is likely to volatilize in a heating process when curing the polyorganosiloxane composition having the adhesiveness imparting agent compounded therein, or heat generation after the curing, heating in a temperature cycle or the like, resulting in a decrease in adhesiveness. When the Mw is more than 15000, the polyorganosiloxane is difficult to uniformly compound into the composition, thus it is hardly producing an effect of improving the adhesiveness.

[Adhesive polyorganosiloxane composition]

A second embodiment of the present invention is an adhesive polyorganosiloxane composition containing (A) 100 parts by mass of a polyorganosiloxane having an alkenyl group, (B) a polyorganohydrogensiloxane having a hydrogen atom in such an amount that the amount of the hydrogen atom in this component becomes 0.1 to 4.0 per alkenyl group in the (A) component, (C) a catalytic amount of a platinum-based catalyst, and (D) 0.05 to 10 parts by mass of the adhesiveness imparting agent in the first embodiment of the present invention.

Hereinafter, the components will be described.

< (A) component >

The polyorganosiloxane having an alkenyl group being the (A) component is a base polymer of the adhesive polyorganosiloxane composition as the second embodiment of the present invention. It is preferable to be a polyorganosiloxane having two or more alkenyl groups in one molecule.

Examples of a molecular structure of the (A) component include linear, cyclic structures and so on. The linear, cyclic structures and so on may have a branch, and a linear structure is preferable which has a main chain basically composed of repeated diorganosiloxane units and has both molecular chain terminals blocked with triorganosiloxy groups.

Examples of the alkenyl group bonded to a silicon atom in the (A) component include the ones having a number of carbon atoms of 2 to 8, such as a vinyl group, an allyl group, a butenyl group, a pentenyl group, a hexenyl group, a heptenyl group and so on, preferably the ones having a number of carbon atoms 2 to 4. The vinyl group is particularly preferable. In the case where the polyorganosiloxane having an alkenyl group being the (A) component is linear, the alkenyl group may be bonded to a silicon atom only at one of the terminal and the middle of a molecular chain, and may be bonded to a silicon atom at both of the terminal and the middle of a molecular chain.

Examples of the organic group bonded to the silicon atom other than the alkenyl group in the (A) component include unsubstituted or halogen-substituted monovalent hydrocarbon groups such as: alkyl groups, in particular, alkyl groups having a number of carbon atoms of 1 to 10, such as a methyl group, an ethyl group, a propyl group, a butyl group, a pentyl group, a hexyl group, a cyclohexyl group, and a heptyl group; aryl groups, in particular, aryl groups having a number of carbon atoms of 6 to 14, such as a phenyl group, a tolyl group, a xylyl group, and a naphthyl group; aralkyl groups such as a benzyl group and a phenethyl group; and halogenated alkyl groups such as a chloromethyl group, a 3-chloropropyl group, and a 3,3,3-trifluoropropyl group. The methyl group or the phenyl group is particularly preferable.

The viscosity (25°C) of the (A) component except a later-described polyorganosiloxane AA is preferably 100 to 100,000 mPa·s, and particularly preferably within a range of 500 to 10,000 mPa·s. When the viscosity (25°C) of the (A) component is within this range, workability of the composition to be obtained is excellent, and physical properties of a cured product to be obtained from this composition are also excellent.

Concrete examples of the (A) component include a dimethylsiloxane methylvinylsiloxane copolymer with both molecular chain terminals blocked with trimethylsiloxy groups, a methylvinylpolysiloxane with both molecular chain terminals blocked with trimethylsiloxy groups, a dimethylsiloxane methylvinylsiloxane methylphenylsiloxane copolymer with both molecular chain terminals blocked with trimethylsiloxy groups, a dimethylpolysiloxane with both molecular chain terminals blocked with dimethylvinylsiloxy groups, a methylvinylpolysiloxane with both molecular chain terminals blocked

with dimethylvinylsiloxy groups, a dimethylsiloxane methylvinylsiloxane copolymer with both molecular chain terminals blocked with dimethylvinylsiloxy groups, a dimethylsiloxane methylvinylsiloxane methylphenylsiloxane copolymer with both molecular chain terminals blocked with dimethylvinylsiloxy groups, a dimethylpolysiloxane with both molecular chain terminals blocked with trivinylsiloxy groups and so on.

Further, copolymers having the siloxane units described below can be exemplified.

A copolymer having a siloxane unit represented by a formula: $R^5{}_3SiO_{1/2}$ ($R^5$ representing an unsubstituted or substituted monovalent hydrocarbon group other than an alkenyl group, the same applying to the following), a siloxane unit represented by a formula: $R^5{}_2R^6SiO_{1/2}$ ($R^6$ representing an alkenyl group, the same applying to the following), a siloxane unit represented by a formula: $R^5{}_2SiO_{2/2}$, and a siloxane unit represented by a formula: $SiO_{4/2}$,

a copolymer having a siloxane unit represented by a formula: $R^5{}_3SiO_{1/2}$, a siloxane unit represented by a formula: $R^5{}_2R^6SiO_{1/2}$, and a siloxane unit represented by a formula: $SiO_{4/2}$,
a copolymer having a siloxane unit represented by a formula: $R^5{}_2R^6SiO_{1/2}$, a siloxane unit represented by a formula: $R^5{}_2SiO_{2/2}$, and a siloxane unit represented by a formula: $SiO_{4/2}$,
a copolymer having siloxane unit represented by a formula: $R^5R^6SiO_{2/2}$, a siloxane unit represented by a formula: $R^5SiO_{3/2}$ or a siloxane unit represented by a formula: $R^6SiO_{3/2}$, can be exemplified.

Examples of $R^5$ in the above formulas include: alkyl groups such as a methyl group, an ethyl group, a propyl group, a butyl group, a pentyl group, a hexyl group, and a heptyl group; aryl groups such as a phenyl group, a tolyl group, a xylyl group, and a naphthyl group; aralkyl groups such as a benzyl group and a phenethyl group; and halogenated alkyl groups such as a chloromethyl group, a 3-chloropropyl group, and a 3,3,3-trifluoropropyl group. Examples of $R^6$ in the formulas include a vinyl group, an allyl group, a butenyl group, a pentenyl group, a hexenyl group, and a heptenyl group.

One kind of the polymers or the copolymers can be used independently, or two or more kinds of them can be used in combination.

Further, as the (A) component, an alkenyl group-containing polyorganosiloxane containing a trifunctional siloxane unit having an aryl group (hereinafter, referred to as a polyorganosiloxane AA) can also be used. In this polyorganosiloxane, the number of alkenyl groups in one molecule is not particularly limited, but two or more is preferable. Hereinafter, the polyorganosiloxane AA will be described.

<Polyorganosiloxane AA>

Examples of the alkenyl group bonded to a silicon atom in the polyorganosiloxane AA include the ones having a number of carbon atoms of 2 to 8, such as a vinyl group, an allyl group, a butenyl group, a pentenyl group, a hexenyl group, and a heptenyl group, the ones having a number of carbon atoms more preferably 2 to 4. The vinyl group is particularly preferable. Such an alkenyl group may be bonded to a silicon atom at either the terminal or the middle of a molecular chain, and may be bonded to a silicon atom at both of the terminal and the middle of a molecular chain.

Examples of the aryl group contained in the trifunctional siloxane unit include the ones having a number of carbon atoms of 6 to 14, such as a phenyl group, a tolyl group, a xylyl group, and a naphthyl group. The phenyl group is particularly preferable.

The polyorganosiloxane AA has an organic group bonded to a silicon atom, in addition to the alkenyl group and the aryl group. Examples of the organic group other than the alkenyl group and the aryl group include: alkyl groups having a number of carbon atoms of 1 to 10, such as a methyl group, an ethyl group, a propyl group, a butyl group, a pentyl group, a hexyl group, a cyclohexyl group, and a heptyl group; and halogenated alkyl groups such as a chloromethyl group, a 3-chloropropyl group, and a 3,3,3-trifluoropropyl group. The methyl group is preferable.

In the polyorganosiloxane AA, the ratio of the trifunctional siloxane unit having an aryl group relative to all constituent units is not particularly limited, but a ratio of 20 to 60 mol% is preferable, and a ratio of 30 to 55 mol% is more preferable from the viewpoint of the handling workability of a composition before curing and the mechanical strength of a cured product. In particular, as the polyorganosiloxane AA, it is preferable to contain the polyorganosiloxane containing a trifunctional siloxane unit (hereinafter, referred to as a $T^{ph}$ unit) represented by a formula: $C_6H_5SiO_{3/2}$ at a ratio of 20 to 60 mol%. The content ratio of the $T^{ph}$ unit relative to all constituent units is more preferably 30 to 55 mol%.

Besides, the polyorganosiloxane AA preferably contains a bifunctional siloxane unit in addition to the trifunctional siloxane unit having an aryl group. Further, a part of the bifunctional siloxane unit preferably contains the alkenyl group (for example, the vinyl group).

Further, as the polyorganosiloxane AA, it is preferable to use at least two kinds of polyorganosiloxanes such as a polyorganosiloxane containing a bifunctional siloxane unit (hereinafter, referred to as a $D^{vi}$ unit) represented by a formula: $CH_3(CH_2{=}CH)SiO_{2/2}$ at a ratio of 10 mol% or less relative to all constituent units, and a polyorganosiloxane containing the $D^{vi}$ unit at a ratio of more than 10 mol%. The polyorganosiloxane AA has such two kinds of polyorganosiloxanes and thereby provides an effect of facilitating adjustment of the hardness and elastic modulus of the cured product.

The viscosity (25°C) of the polyorganosiloxane AA is preferably 50,000 to 6,000,000 mPa·s, and is more preferably 200,000 to 3,000,000 mPa·s. When the viscosity (25°C) of the polyorganosiloxane AA falls within the range, the workability of the composition to be obtained is excellent and the physical properties of the cured product of the composition is also excellent.

<(B) component>

The polyorganohydrogensiloxane being the (B) component reacts with the (A) component and acts as a cross-linking component. The molecular structure of the (B) component is not particularly limited, and, for example, various kinds of polyorganohydrogensiloxanes in linear, cyclic, branched, three-dimensional network (resinoid) structures can be used.

In the case of using the polyorganosiloxane AA as the (A) component, the polyorganohydrogensiloxane being the (B) component preferably has two or more, preferably three or more hydrogen atoms bonded to silicon atoms, namely, hydrosilyl groups (Si-H groups) in one molecule. When the polyorganohydrogensiloxane being the (B) component is in a linear structure, these Si-H groups may be located only at one of the terminal and the middle of a molecular chain, and may be located at both of them. The polyorganohydrogensiloxane having Si-H groups at both terminals of a molecular chain is preferable used in the point that the viscosity of the composition before curing can be decreased and the hardness of the cured product can be appropriately adjusted. Further, the number of silicon atoms (degree of polymerization) in one molecule of the (B) component is preferably 2 to 1,000 and more preferably 3 to 100.

When the polyorganosiloxane AA as the (A) component is used, the number of hydrogen atoms in one molecule of the polyorganohydrogensiloxane being the (B) component is preferably 1 or more, and more preferably 2 or more. The number of silicon atoms (degree of polymerization) in one molecule of the (B) component is preferably 2 to 30, and more preferably 3 to 15.

Both in the case of using the polyorganosiloxane AA as the (A) component and in the case of using another alkenyl group-containing polyorganosiloxane, it is preferable to use, as the (B) component, a polyorganohydrogensiloxane represented by an average composition formula: $R^7_pH_qSiO_{(4-p-q)/2}$ (in the formula, $R^7$ representing an unsubstituted or substituted monovalent hydrocarbon group having a number of carbon atoms of 1 to 14 and more preferably 1 to 10 except an alkenyl group, and p and q being positive numbers satisfying $0.7 \leq p \leq 2.1$, $0.001 \leq q \leq 1.0$, and $0.8 \leq p + q \leq 3.0$, and more preferably $1.0 \leq p + q \leq 2.5$).

Examples of the above $R^7$ include: alkyl groups such as a methyl group, an ethyl group, a propyl group, an isopropyl group, a butyl group, an isobutyl group, a t-butyl group, a pentyl group, a neopentyl group, a hexyl group, a cyclohexyl group, an octyl group, a nonyl group, and a decyl group; aryl groups such as a phenyl group, a tolyl group, a xylyl group, and a naphthyl group; aralkyl groups such as a benzyl group, a phenylethyl group, and a phenylpropyl group; and groups with a part or all of hydrogen atoms in these hydrocarbon groups substituted by halogen atoms, such as a chloromethyl group, a 3-chloropropyl group, a bromoethyl group, and a 3,3,3-trifluoropropyl group. The $R^7$ is preferably the alkyl group or the aryl group, and more preferably the methyl group or the phenyl group.

Concrete example of the (B) component include a methylhydrogenpolysiloxane with both molecular chain terminals blocked with trimethylsiloxy groups, a dimethylsiloxane methylhydrogensiloxane copolymer with both molecular chain terminals blocked with trimethylsiloxy groups, a dimethylsiloxane methylhydrogensiloxane methylphenylsiloxane copolymer with both molecular chain terminals blocked with trimethylsiloxy groups, a dimethylpolysiloxane with both molecular chain terminals blocked with dimethylhydrogensiloxy groups, a dimethylsiloxane methylhydrogensiloxane copolymer with both molecular chain terminals blocked with dimethylhydrogensiloxy groups, a dimethylsiloxane methylphenylsiloxane copolymer with both molecular chain terminals blocked with dimethylhydrogensiloxy groups, a methylphenylpolysiloxane with both molecular chain terminals blocked with dimethylhydrogensiloxy groups, a diphenylpolysiloxane with both molecular chain terminals blocked with dimethylhydrogensiloxy groups and so on.

Further, as the (B) component, copolymers having the siloxane units described below can be exemplified.

A copolymer having a siloxane unit represented by a formula: $R^5_3SiO_{1/2}$ ($R^5$ being as described above), a siloxane unit represented by a formula: $R^5_2HSiO_{1/2}$, and a siloxane unit represented by a formula: $SiO_{4/2}$,

a copolymer having a siloxane unit represented by a formula: $R^5_2HSiO_{1/2}$, and a siloxane unit represented by a formula: $SiO_{4/2}$,
a copolymer having a siloxane unit represented by a formula: $R^5HSiO_{2/2}$, a siloxane unit represented by a formula: $R^5SiO_{3/2}$ or a siloxane unit represented by a formula: $HSiO_{3/2}$, and so on can be exemplified.

One kind of the polymers or the copolymers can be used independently, or two or more kinds of them can be used in combination.

In particular, in the case of using the polyorganosiloxane AA as the (A) component, it is preferable to contain a polyorganohydrogensiloxane having a $T^{Ph}$ unit or a $D^{Ph2}$ unit as the (B) component from the viewpoint of compatibility with the (A) component. Note that the $D^{Ph2}$ unit is a bifunctional siloxane unit represented by a formula: $(C_6H_5)_2SiO_{2/2}$.

The compounding amount of the polyorganohydrogensiloxane being the (B) component is an effective amount for curing the (A) component, and in the case of using an alkenyl group-containing polyorganosiloxane other than the polyorganosiloxane AA as the (A) component, it is compounded so that an amount of the Si-H group contained in the (B) component becomes 0.1 to 4.0 and more preferably 1.0 to 3.0 per alkenyl group (for example, a vinyl group) in the (A) component. When it is less than 0.1, the curing reaction does not proceed, and it may become difficult to obtain a cured product, whereas when it is more than 4.0, many unreacted Si-H groups remain in a cured product, and therefore the physical properties of the cured product may change with time.

Further, in the case of using the polyorganosiloxane AA as the (A) component, the compounding amount of the (B) component is such an amount that an amount of the Si-H group contained in the (B) component becomes 0.5 to 2.5 and more preferably 0.7 to 2.0 per alkenyl group (for example, a vinyl group) in the (A) component. When it is less than 0.5, the curing reaction does not proceed, and it may become difficult to obtain a cured product, whereas when it is more than 2.5, many unreacted Si-H groups remain in a cured product, and therefore the physical properties of the cured product may change with time.

<(C) component>

The platinum-based catalyst being the (C) component is a catalyst that proceeds the addition reaction (hydrosilylation reaction) between the alkenyloxy group in the (A) component and the Si-H group in the (B) component. As the (C) component, for example, a chloroplatinic acid, an alcohol solution of the chloroplatinic acid, a platinum complex having olefines, a vinyl group-containing siloxane, or an acetylene compound as a ligand and so on can be used.

The compounding amount of the (C) component is not particularly limited as along as it is an effective amount as the catalyst for the hydrosilylation reaction, and is 0.1 to 1,000 ppm, more preferably 1 to 500 ppm, and furthermore preferably 1 to 20 ppm, when it is converted into a platinum element, relative to the total amount of the (A) component and the (B) component. In the case where the compounding amount is within this range, the addition reaction is accelerated to provide enough curing and economical advantage.

<(D) component>

The (D) component is a component that imparts adhesiveness to the polyorganosiloxane composition in the second embodiment of the present invention. As the (D) component, an adhesiveness imparting agent being the above-described first embodiment, namely, the polyorganosiloxane containing one kinds of siloxane unit selected from among the (a) $T1^{ep}$ unit, $D1^{ep}$ unit, and $M1^{ep}$ unit and the (b) $D1^{vi}$ unit, and having an Mw of 1000 to 15000 is used.

The compounding amount of the (D) component is 0.05 to 10 parts by mass relative to 100 parts by mass of the (A) component. If the compounding amount of the (D) component is too much, the (D) component does possibly not contribute to the improvement in adhesiveness. A more preferable compounding amount of the (D) component is 0.1 to 5 parts by mass.

In the composition in the second embodiment of the present invention, well-known additives can be compounded as necessary in addition to the above-described (A) component, (B) component, (C) component, and (D) component. For example, a reinforcing filler such as fumed silica, and a non-reinforcing filler such as calcium carbonate, calcium silicate, titanium dioxide, ferric oxide, carbon black, zinc oxide, wavelength adjusting agent and so on may be compounded in a range not impairing the object of the present invention. When the composition is used as a sealant of an LED device, it is preferable to compound the fumed silica, wavelength adjusting agent and so on.

Further, in the case of using the polyorganosiloxane AA as the (A) component, an (E) isocyanurate compound having an alkoxy group can be compounded. As the (E) isocyanurate compound having an alkoxy group, for example, isocyanuric acid derivatives having one or more alkoxysilyl groups as represented by [Chemical Formula 1] to [Chemical Formula 4] can be exemplified. One kind of the isocyanuric acid derivatives can be used independently, or two or more kinds of them can be used in mixture.

[Chemical Formula 1]

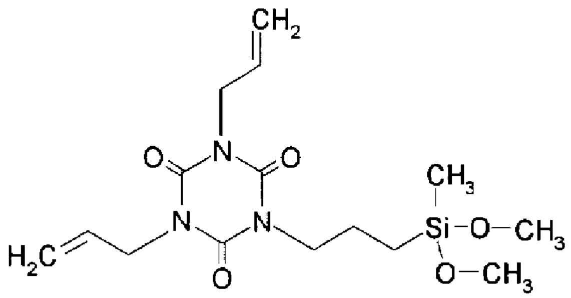

[Chemical Formula 2]

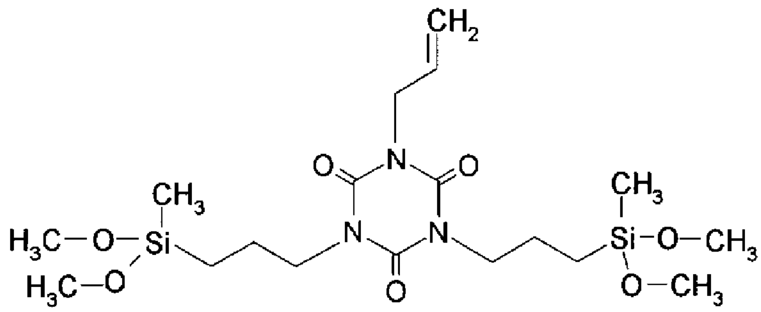

[Chemical Formula 3]

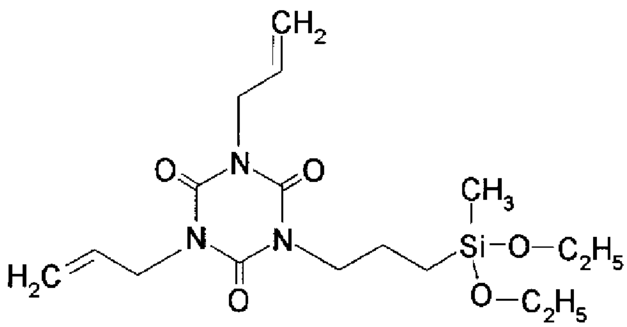

[Chemical Formula 4]

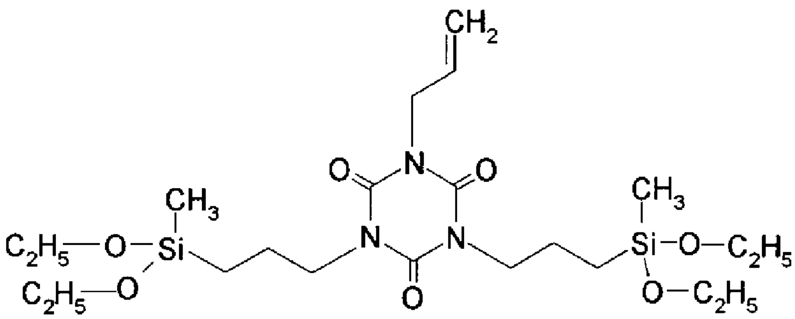

These isocyanuric acid derivatives can be manufactured by subjecting 1,3,5-triallylisocyanurate and alkyldialkoxysilane to a hydrosilylation reaction in the presence of a platinum catalyst.

The compounding amount of the (E) component is preferably 0.05 to 5 parts by mass and more preferably 0.1 to 3 parts by mass, relative to 100 parts by mass of the (A) component. By compounding the (E) component, the adhesiveness with PPA or the like of the cured product can be further improved.

The adhesive polyorganosiloxane composition in the second embodiment is prepared by uniformly mixing the above-described components, and its curability can be arbitrarily adjusted by addition of a reaction inhibitor. Examples of the inhibitor for the curing reaction include acetylene alcohol such as 3-methyl-1-butyne-3-ol and 2-phenyl-3-butyne-2-ol, and a maleic acid derivative such as maleic acid diallyl. By using such a reaction inhibitor, the adhesive polyorganosiloxane composition can be used in one liquid.

Further, the adhesive polyorganosiloxane composition can also be stored while separated in two liquids to prevent curing from proceeding, and the two liquids can be mixed together in use for curing. For the two-liquid-mixing type, it is necessary to avoid storage of the polyorganohydrogensiloxane being the (B) component and the platinum-based catalyst being the (C) component in the same wrapper in terms of the risk of a dehydrogenation reaction.

The viscosity of the adhesive polyorganosiloxane composition in the second embodiment thus obtained is preferably in a range of 100 to 50,000 Pa·s and particularly preferably in a range of 300 to 10,000 Pa·s as a value measured by a rotational viscometer at 25 °C.

The composition in the second embodiment is cured by being heated as necessary. Note that the curing condition is not particularly limited, but the composition may cure in about 1 minute to 10 hours and more preferably in about 30 minutes to 6 hours normally at 40 to 200°C and more preferable 60 to 170°C.

The cured product has a sufficient rubber hardness and has excellent adhesiveness to noble metals such as Ag, Au, and heat-resistant plastic such as PPA. Further, the adhesiveness never decreases due to heat generation from the light emitting element, heating in the temperature cycle or the like. Accordingly, the cured product is suitable, for example, as the sealing material for a emitting element in an LED device and a material of a functional lens. The LED device formed with a sealing layer of the cured product of the polyorganosiloxane composition is excellent in reliability because the adhesiveness between the sealing layer and the base material such as PPA is excellent and peeling hardly occurs at the boundary face.

EXAMPLES

Hereinafter, the present invention will be concretely described using examples but is not limited to the examples.

In the following description, an M unit, an $M^{vi}$ unit, an $M^H$ unit, a D unit, a $D^{Vi}$ unit, a $D^H$ unit, a $D^{Ph2}$ unit, a T unit, a $T^{Ph}$ unit, and a Q unit represent siloxane units represented by the following formulas respectively. Further, the methyl group is referred to as Me, the phenyl group is referred to as Ph, and the vinyl group is referred to as Vi, respectively in some cases.

| | |
|---|---|
| M unit | $(CH_3)_3SiO_{1/2}$ |
| $M^{vi}$ unit | $(CH_3)_2(CH_2=CH)SiO_{1/2}$ |
| $M^H$ unit | $(CH_3)_2HSiO_{1/2}$ |
| D unit | $(CH_3)_2SiO_{2/2}$ |
| $D^{Vi}$ unit | $(CH_3)(CH_2-CH)SiO_{2/2}$ |
| $D^H$ unit | $(CH_3)HSiO_{2/2}$ |
| $D^{Ph2}$ unit | $(C_6H_5)_2SiO_{2/2}$ |
| T unit | $CH_3SiO_{3/2}$ |
| $T^{Ph}$ unit | $C_6H_5SiO_{3/2}$ |
| Q unit | $SiO_{4/2}$ |

Further, the viscosity is a value at 25°C unless otherwise stated.

[Preparation of the adhesiveness imparting agent]

First, adhesiveness imparting agents (D1) to (D6) were prepared as follows.

(Synthesis Example 1)

In a 2-L reaction container, 185.9 g (0.788 mol) of γ-glycidoxypropyltrimethoxysilane, 347.1 g (2.888 mol) of dimethyldimethoxysilane, 178.5 g (1.313 mol) of methyltrimethoxysilane, 34.7 g (0.263 mol) of methylvinyldimethoxysilane, and 105 g of toluene were charged, and then 1.02 g of 6N sodium hydroxide (NaOH) solution, and 53 g of ion-exchange water (the ion-exchange water to be added at this stage is referred to as ion-exchange water (1)) were put thereinto and stirred.

When a mixture in the reaction container was heated until the liquid temperature became 30°C, a partial

hydrolysis reaction of methoxy groups of the above-described four kinds of silane compounds (γ-glycidoxypropyltrimethoxysilane, dimethyldimethoxysilane, methyltrimethoxysilane, and methylvinyldimethoxysilane) was started to generate heat. Even after the heating was stopped, the heat generation continued, and the reaction mixture became transparent and increased in temperature up to 50°C. The stirring was continued, and at the point when the temperature started to decrease, 60 g of ion-exchange water (the ion-exchange water to be added at this stage is referred to as ion-exchange water (2)) was added, and the partial hydrolysis reaction was further continued. After the addition of the ion-exchange water (2), the reaction mixture immediately became transparent and uniform and started heat generation, and increased in temperature up to 60°C. Thereafter, the inside of the reaction container was heated to a reflux temperature (66°C) using an oil bath. Then, the heating reflux state was continued for 1 hour, and the reaction mixture was then cooled down to room temperature.

Subsequently, 500 g of toluene was added to the obtained reaction mixture, and they were heated again up to the reflux temperature, and methanol being a reaction product was distilled off together with toluene. When the distillation of methanol was completed and the reaction mixture was brought into the reflux state at a boiling point of toluene, the reaction mixture was cooled and returned to room temperature.

Into the reaction mixture thus obtained, 0.72 g of glacial acetic acid was added and they were stirred for 1 hour to neutralize the previously added sodium hydroxide. Thereafter, while the reaction mixture was being heated to the reflux temperature again using the oil bath, nitrogen was flowed into the reaction container to remove a solvent under a reduced pressure of 80°C/25 mmHg, and concentration was performed until distillate was no longer produced. Then, the liquid in the reaction container was cooled, and then subjected to filtration using Celite (manufactured by World Minerals Inc. in U.S.), whereby the adhesiveness imparting agent (D1) was obtained.

(Synthesis Examples 2 to 3)

In a reaction container, γ-glycidoxypropyltrimethoxysilane, dimethyldimethoxysilane, methyltrimethoxysilane, methylvinyldimethoxysilane, and toluene in the same amounts as those in Synthesis Example 1 were charged. Then, the same operation as that in Synthesis Example 1 except that the ion-exchange water (1) and the ion-exchange water (2) in masses listed in Table 1 were added to change the degrees of the partial hydrolysis reaction and the condensation reaction was performed, whereby the adhesiveness imparting agents (D2) to (D3) were obtained.

(Synthesis Example 4)

In a reaction container, 212.5 g (0.900 mol) of γ-glycidoxypropyltrimethoxysilane, 577.0 g (4.800 mol) of dimethyldimethoxysilane, 39.7 g (0.300 mol) of methylvinyldimethoxysilane, and 105 g of toluene were charged, and the same operation as that in Synthesis Example 1 was performed, whereby the adhesiveness imparting agent (D4) was obtained. Note that also in the Synthesis Example 4, the ion-exchange water (1) and the ion-exchange water (2) in masses listed in Table 1 were added as in Synthesis Examples 2 to 3 to change the degrees of the partial hydrolysis reaction and the condensation reaction from those in Synthesis Example 1.

(Synthesis Example 5)

In a reaction container, γ-glycidoxypropyltrimethoxysilane, dimethyldimethoxysilane, methyltrimethoxysilane, methylvinyldimethoxysilane, and toluene in the same amounts as those in Synthesis Example 1 were charged. Then, the same operation as that in Synthesis Example 1 except that the ion-exchange water (1) and the ion-exchange water (2) in masses listed in Table 1 were added to change the degrees of the partial hydrolysis reaction and the condensation reaction was performed, whereby the adhesiveness imparting agent (D5) was obtained.

(Synthesis Example 6)

In a 2-L reaction container, 124.0 g (0.525 mol) of γ-glycidoxypropyltrimethoxysilane, 119.0g (0.875 mol) of methyltrimethoxysilane, 256.6 g (1.050 mol) of diphenyldimethoxysilane, 105.2 g (0.875 mol) of dimethyldimethoxysilane, 23.1 g (0.175 mol) of methylvinyldimethoxysilane, and 105 g of toluene were charged. Then, the same operation as that in Synthesis Example 1 was performed, whereby the adhesiveness imparting agent (D6) was obtained.

Next, the copolymerization composition ratios of the adhesiveness imparting agents (D1) to (D6) obtained in Synthesis Examples 1 to 6 respectively were measured using deuterochloroform as a solvent and using $^1$H-NMR (manufactured by BRUKER Corporation, apparatus name; ARX-400).

As a result of measurement, it was found that each of the adhesiveness imparting agents (D1) to (D3) and (D5) had a trifunctional siloxane unit (hereinafter, referred to as a $T^{ep}$ unit) represented by a formula: $RSiO_{3/2}$ (in the formula, R representing a γ-glycidoxypropyl group represented by the following chemical formula),

[Chemical Formula 5]

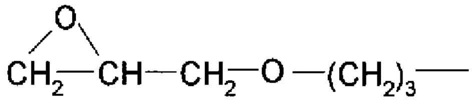

a T unit, a D unit, a $D^{vi}$ unit, and a methoxy group (hereinafter, referred to as OMe), and their molar abundance ratios of the units and the methoxy group (t1:t2:d1:d2:e) were as those listed in Table 1.

Further, the adhesiveness imparting agent (D4) did not contain the T unit but had the $T^{ep}$ unit, the D unit, the $D^{vi}$ unit, and the methoxy group (OMe), and t1, d1, d2, and e in the molar abundance ratio of the units and the methoxy group (t1:t2:d1:d2:e) were as those listed in Table 1.

Further, the adhesiveness imparting agent (D6) had the $T^{ep}$ unit, the T unit, the D unit, the $D^{vi}$ unit, the $D^{Ph}$ unit, and the methoxy group (OMe), and the molar abundance ratio of the units and the methoxy group (t1:t2:d1:d1:d2:d3:e) was 15:25:25:5:30:15 as listed in Table 1.

Furthermore, the weight-average molecular weight (Mw), the number average molecular weight (Mn), the degree of dispersion (Mw/Mn), the nonvolatile content (mass%), the viscosity (mPa·s), the epoxy equivalent (g/eq), the epoxy group content (mmol/g), the yield amount, and the yield rate of each of the obtained adhesiveness imparting agents (D1) to (D6) were measured. These measured values are listed in Table 1 together with the amounts of the starting materials used.

Mw and Mn are values measured using a gel permeation chromatography (GPC) apparatus (manufactured by Tosoh Corporation, apparatus name; HLC-8220 GPC) using THF (tetrahydrofuran) as a solvent, and converted into polystyrene. The degree of dispersion is a numerical value representing the molecular weight distribution and is found by weight-average molecular weight (Mw)/number average molecular weight (Mn). The degree of dispersion indicates that as it becomes closer to 1, the molecular weight distribution is narrower. Further, nonvolatile content (mass%) is a value measured under the heating condition of 150°C × 1 hour, and the viscosity is a measured value at 25°C. Further, the yield rate is calculated by the following calculation formula.

$$\text{Yield rate (\%)} = \text{yield amount (g)/theoretical hydrolysate amount (g)} \times 100$$

where the theoretical hydrolysate amount (g) is the total of the hydrolysate amounts of silanes being the starting materials (number of moles × hydrolysate molecular weight).

[Table 1]

| | | | S.Exam. 1 | S.Exam. 2 | S.Exam. 3 | S.Exam. 4 | S.Exam. 5 | S.Exam. 6 |
|---|---|---|---|---|---|---|---|---|
| Amount of Starting Material (g) | γ-glycidoxypropyltrimethoxysilane | | 185.9 | 185.9 | 185.9 | 212.5 | 185.9 | 124.0 |
| | Diphenyldimethoxysilane | | 0.0 | 0.0 | 0.0 | 0.0 | 0.0 | 256.6 |
| | Dimethyldimethoxysilane | | 347.1 | 347.1 | 347.1 | 577 | 347.1 | 105.2 |
| | Methyltrimethoxysilane | | 178.5 | 178.5 | 178.5 | 0 | 178.5 | 119.0 |
| | Methylvinyldimethoxysilane | | 34.7 | 34.7 | 34.7 | 39.7 | 34.7 | 23.1 |
| | Ion-exchange Water (1) | | 53 | 45 | 50 | 55 | 40 | 53 |
| | Ion-exchange Water (2) | | 60 | 45 | 50 | 60 | 40 | 60 |
| Physical Properties of Product | Composition Ratio | Mole Ratio t1 of $T^{ep}$ Unit | 15.0 | 15.0 | 15.0 | 15.0 | 15.0 | 15.0 |
| | | Mole Ratio t2 of T Unit | 25.0 | 25.0 | 25.0 | 25.0 | 25.0 | 25.0 |
| | | Mole Ratio d1 of D Unit | 55.0 | 55.0 | 55.0 | 55.0 | 55.0 | 25.0 |
| | | Mole Ratio d2 of $D^{vi}$ Unit | 4.5 | 4.5 | 4.6 | 4.5 | 4.6 | 5.0 |
| | | Mole Ratio d3 of $D^{PH}$ Unit | 0.0 | 0.0 | 0.0 | 0.0 | 0.0 | 30.0 |
| | | Mole Ratio e of OMe | 15.0 | 41.8 | 27.5 | 14.9 | 61.1 | 15.0 |
| | Yield Amount (g) | | 441 | 444 | 450 | 473 | 437 | 424 |
| | Yield Rate (%) | | 96.8 | 97.4 | 98.7 | 89.0 | 95.8 | 97.7 |
| | Weight-average Molecular Weight (Mw) | | 7455 | 1900 | 4110 | 1860 | 900 | 2160 |
| | Number-average Molecular Weight (Mn) | | 2178 | 1038 | 1779 | 1210 | 590 | 1090 |
| | Degree of Dispersion (Mw/Mn) | | 3.42 | 1.83 | 2.31 | 1.54 | 1.53 | 1.98 |
| | Nonvolatile Content (mass%) | | 92.6 | 84.6 | 92.1 | 81.6 | 51.3 | 99.0 |
| | Viscosity (mPa·s) | | 321 | 48 | 141 | 30 | 22 | 13400 |
| | Epoxy Equivalent (g/eq) | | 889 | 598 | 618 | 565 | 542 | 885 |
| | Epoxy Group Content (mmol/g) | | 1.12 | 1.67 | 1.62 | 1.77 | 1.85 | 1.13 |

S.Exam. 1 to S.Exam. 6 = Synthesis Example 1 to Synthesis Example 6

Example 1

A polyorganosiloxane composition was prepared by mixing:

(A1) 70.54 parts by mass (hereinafter, referred to only as parts) of linear dimethylpolysiloxane with both molecular chain terminals blocked with dimethylvinylsiloxy groups (viscosity of 3000 mPa·s);
(A2) 22.95 parts of a 6:4 (nonvolatile content) mixture of linear dimethylpolysiloxane with both molecular chain terminals blocked with dimethylvinylsiloxy groups (viscosity of 3000 mPa·s) and branched methylpolysiloxane represented by an average unit formula: $M_5M^{vi}Q_8$ (Mn = 2760, Mw/Mn = 1.27);
(B1) 5.00 parts of methylhydrogenpolysiloxane having hydrogen atoms bonded to silicon atoms at both terminals and a middle of a molecular chain represented by a unit formula: $M^HD^H{}_3D_7M^H$ (a mol (equivalent weight) ratio of the SiH groups in the (B) component relative to the vinyl groups in the (A) component = 1.65);
(C) 0.015 parts of a platinum complex solution having tetramethyltetravinylcyclotetrasiloxane as a ligand (Pt content of 1.8 mass%),
1.5 parts of linear dimethylpolysiloxane with both molecular chain terminals blocked with dimethylvinylsiloxy groups (viscosity of 3000 mPa· s) solution (1 mass%) of 2-phenyl-3-butyne-2-ol being a reaction inhibitor, and
3.03 parts of the adhesiveness imparting agent (D1) obtained in Synthesis Example 1.

Examples 2 to 6, Comparative Examples 1 to 2

The (A1), (A2) used in Example 1, (A3) a linear dimethylpolysiloxane with both molecular chain terminals blocked with dimethylvinylsiloxy groups (viscosity of 10,000 mPa·s), a (A4) 4:6 (nonvolatile content) mixture of a linear dimethylpolysiloxane with both molecular chain terminals blocked with dimethylvinylsiloxy groups (viscosity of 10,000 mPa·s) and a branched methylpolysiloxane represented by an average unit formula: $M_5M^{vi}Q_8$ (Mn = 2760, Mw/Mn = 1.27), the (B1) used in Example 1, (B2) a methylhydrogenpolysiloxane having a hydrogen atom bonded to silicon at a middle of a molecular chain represented by a unit formula: $MD^H{}_{12}D_{28}M$, the (C) platinum complex solution having tetramethyltetravinylcyclotetrasiloxane as a ligand (Pt content of 1.8 mass%), and a reaction inhibitor, were compounded at ratios listed in Table 2. Further, as the adhesiveness imparting agent, the adhesiveness imparting agents (D2) to (D5) obtained in Synthesis Examples 2 to 5 or γ-glycidoxypropyltrimethoxysilane (epoxy group content of 4.51 mmol/g) were compounded at ratios listed in Table 2 to prepare polyorganosiloxane compositions.

The viscosities of the polyorganosiloxane compositions thus obtained in Examples 1 to 6 and Comparative Example 1 to 2 were measured using a rotational viscometer at 25°C. Further, as indicated below, the obtained polyorganosiloxane compositions were subjected to thermogravimetric analysis (TGA). Further, a package test (1) was performed on the polyorganosiloxane compositions to investigate adhesiveness under temperature rise. The results are listed in a low column in Table 2.

[TGA measurement]

Samples of the polyorganosiloxane compositions were left at 150°C for 1 hour and their weight decrease ratios were measured by a TGA apparatus (manufactured by Seiko Instruments, Inc. apparatus name; TG/DTA6200).

[Package test (1)]

Samples of the polyorganosiloxane compositions were filled in a reflector made of PPA of a 5050-type LED package (SAYO SEIKI SEISAKUSYO CO., Ltd.), then heated at 80°C for 1 hour, and then heated at 150°C for 5 hours to be cured. Subsequently, aging was performed for 168 hours at 85°C in an atmosphere of 85 %RH, and then heated with a profile illustrated in Fig. 1 to be increased in temperature. More specifically, the samples were increased in temperature from 40°C at a rate of 4.7 °C/sec for about 30 seconds and kept at 180°C for 1 minute, and then further increased in temperature at a rate of 4.5 °C/sec for 20 seconds and kept at 270°C for 10 seconds. Then, the temperature at which the cured compositions peeled off from the reflector made of PPA were found.

[Table 2]

| | | | Exam. 1 | Exam. 2 | Exam. 3 | Exam. 4 | Exam. 5 | Exam. 6 | C.E. 1 | C.E. 2 |
|---|---|---|---|---|---|---|---|---|---|---|
| Composition (Parts by Mass) | (A1) Linear Vinyl Group-containing Silicone Polymer | | 70.54 | 70.54 | 70.54 | 70.54 | 15.08 | 10.20 | 70.54 | 70.54 |
| | (A2) Vinyl Group-containing Silicone Polymer Mixture | | 22.95 | 22.95 | 22.95 | 22.95 | - | - | 22.95 | 22.95 |
| | (A3) Linear Vinyl Group-containing Silicone Polymer | | - | - | - | - | 38.46 | 40.56 | - | - |
| | (A4) Vinyl Group-containing Silicone Polymer Mixture | | - | - | - | - | 33.74 | 30.16 | - | - |
| | (B1) Hydrogenpolysiloxane | | 5.00 | 5.00 | 5.00 | 5.00 | 8.55 | - | 5.00 | 5.00 |
| | (B2) Hydrogenpolysiloxane | | - | - | - | - | - | 14.91 | - | - |
| | (D) Adhesiveness Imparting Agent | Adhesiveness Imparting Agent (D1) | 3.03 | - | - | - | 2.24 | 2.24 | - | - |
| | | Adhesiveness Imparting Agent (D2) | - | 2.02 | - | - | - | - | - | - |
| | | Adhesiveness Imparting Agent (D3) | - | - | 2.09 | - | - | - | - | - |
| | | Adhesiveness Imparting Agent (D4) | - | - | - | 1.91 | - | - | - | - |
| | | Adhesiveness Imparting Agent (D5) | - | - | - | - | - | - | - | 1.83 |
| | | γ-glycidoxypropyltrimethoxysilane | - | - | - | - | - | - | 0.75 | - |
| | 1% Solution of 2-phenyl-3-butyne-2-ol | | 1.50 | 1.50 | 1.50 | 1.50 | 1.50 | 1.50 | 1.50 | 1.50 |
| | (C) Platinum Catalyst | | 0.015 | 0.015 | 0.015 | 0.015 | 0.03 | 0.03 | 0.015 | 0.015 |
| H/Vi ((A) Component and (B) Component) | | | 1.65 | 1.65 | 1.65 | 1.65 | 1.90 | 2.95 | 1.65 | 1.65 |

(continued)

| | | Exam. 1 | Exam. 2 | Exam. 3 | Exam. 4 | Exam. 5 | Exam. 6 | C.E. 1 | C.E. 2 |
|---|---|---|---|---|---|---|---|---|---|
| Characteristics | Viscosity (mPa·s) | 2600 | 2500 | 2500 | 2500 | 5300 | 3800 | 2400 | 2500 |
| | Weight Decrease Ratio (%) | 0.09 | 0.24 | 0.22 | 0.22 | 0.16 | 0.20 | 0.59 | 0.82 |
| | Peeling from PPA Base Material | No Peeling | No Peeling | No Peeling | No Peeling | No Peeling | No Peeling | Peeled at 158°C | Peeled at 223°C |
| Exam. 1 to Exam. 6 = Example 1 to Example 6 C. E. 1 to C. E. 2 = Comparative Example 1 to Comparative Example 2 | | | | | | | | | |

From Table 1 and Table 2, the following is found.

The polyorganosiloxane compositions in Examples 1 to 6 obtained by compounding the adhesiveness imparting agents (D1) to (D4) each containing (a) a $T^{ep}$ unit having an epoxy group and (b) a $D^{vi}$ unit being the bifunctional siloxane unit having an alkenyl group, and having an Mw in a range of 1000 to 15000, in an addition reaction type polyorganosiloxane composition, are substantially low in weight decrease ratio by TGA as compared with the polyorganosiloxane compositions in Comparative Examples 1 to 2 in which γ-glycidoxypropyltrimethoxysilane or the adhesiveness imparting agent (D-5) having an Mw of 1000 or less is compounded as the adhesiveness imparting agent, showing that volatilization of the adhesiveness imparting agent due to heating hardly occurs.

It is also found that peeling of the sealing layers composed of the polyorganosiloxane compositions in Comparative Examples 1 to 2 occurs at the boundary face with the base material (reflector) made of PPA in the temperature rise process after curing, whereas there is no peeling observed in the sealing layers composed of the polyorganosiloxane compositions in Examples 1 to 6, showing that excellent adhesiveness to PPA is maintained.

Next, other examples of using an alkenyl group-containing polyorganosiloxane containing a trifunctional siloxane unit having an aryl group as a base polymer will be described.

[Synthesis of an intermediate product AA (silicone resin having a methoxy group)]

In a mixture of (Aa1) 129 g (1 mol) of dimethyldichlorosilane, (Aa2) 253 g (1 mol) of diphenyldichlorosilane, and (Aa3) 212 g (1 mol) of phenyltrichlorosilane, a methanol solution composed of 38 g of water and 237 g of methanol was dripped to perform cohydrolysis. After finish of the dripping, heating was performed for 30 minutes at a reflux temperature of 60 to 70°C to complete the cohydrolysis reaction. Thereafter, the reaction mixture was cooled, and 254 g of methanol was added thereto, and they were stirred for 15 minutes and then left standing still for 30 minutes for liquid separation. The reaction mixture was separated such that a mixed solution of hydrochloric acid and methanol became an upper layer and a reaction product became a lower layer.

Subsequently, 254 g of methanol was added to the reaction product being the lower layer, and they were subjected to heating and distillation, whereby the hydrochloric acid content in the reaction product was distilled off together with methanol. Thus, a silicone resin AA having a methoxy group represented by an average unit formula: $(Me_2SiO_{2/2})_{30}(Me_2SiO_{1/2}OMe)_4(Ph_2SiO_{2/2})_{30}(Ph_2SiO_{1/2}OMe)_3(PhSiO_{3/2})_{27}\{PhSiO_{1/2}(OMe)_2\}_3(PhSiO_{2/2}OMe)_3$ was obtained.

In the average unit formula representing the silicone resin AA, an (aa1) unit: $(Me_2SiO_{2/2})_{30}(Me_2SiO_{1/2}OMe)_4$ was produced from the starting material (Aa1), an (aa2) unit: $(Ph_2SiO_{2/2})_{30}(Ph_2SiO_{1/2}OMe)_3$ was produced from the starting material (Aa2), and an (aa3) unit: $(PhSiO_{3/2})_{27}\{PhSiO_{1/2}(OMe)_2\}_3(PhSiO_{2/2}OMe)_3$ was produced from the starting material (Aa3). The molar ratio of the units is (aa1):(aa2):(aa3) = 34:33:33≈1:1:1.

[Synthesis of an intermediate product BB (silicone resin having a methoxy group)]

In a mixture of (Aa1) 129 g (1 mol) of dimethyldichlorosilane, (Aa2) 253 g (1 mol) of diphenyldichlorosilane, and (Aa3) 635 g (3 mol) of phenyltrichlorosilane, a methanol solution composed of 53 g of water and 330 g of methanol was dripped to perform cohydrolysis. After finish of the dripping, heating was performed for 30 minutes at a reflux temperature of 60 to 70°C to complete the cohydrolysis reaction. Thereafter, the reaction mixture was cooled, and 254 g of methanol was added thereto, and they were stirred for 15 minutes and then left standing still for 30 minutes for liquid separation. The reaction mixture was separated such that a mixed solution of hydrochloric acid and methanol became an upper layer and a reaction product became a lower layer.

Subsequently, 435 g of methanol was added to the reaction product being the lower layer, and they were subjected to heating and distillation, whereby the hydrochloric acid content in the reaction product was distilled off together with methanol. Thus, a silicone resin BB having a methoxy group represented by an average unit formula: $(Me_2SiO_{2/2})_{17}(Me_2SiO_{1/2}OMe)_3(Ph_2SiO_{2/2})_{16}(Ph_2SiO_{1/2}OMe)_4(PhSiO_{3/2})_{54}\{PhSiO_{1/2}(OMe)_2\}_3(PhSiO_{2/2}OMe)_3$ was obtained.

In the average unit formula representing the silicone resin BB, an (aa1) unit: $(Me_2SiO_{2/2})_{17}(Me_2SiO_{1/2}OMe)_2$ was produced from the starting material (Aa1), an (aa2) unit: $(Ph_2SiO_{2/2})_{16}(Ph_2SiO_{1/2}OMe)_4$ was produced from the starting material (Aa2), and an (aa3) unit: $(PhSiO_{3/2})_{54}\{PhSiO_{1/2}(OMe)_2\}_3(PhSiO_{2/2}OMe)_3$ was produced from the starting material (Aa3). The molar ratio of the units is (aa1):(aa2):(aa3) = 20:20:60=1:1:3.

[Synthesis of an intermediate product CC (polymethylsiloxane having vinyl groups at a terminal and a side chain)]

In a 5-L reaction container, 339.0 g (1.14 mol) of octamethylcyclotetrasiloxane, 1.6 g (0.0086 mol) of divinyltetramethyldisiloxane, and 57.7 g (0.17 mol) of tetramethyltetravinylcyclotetrasiloxane were charged, 0.02 g of potassium hydroxide corresponding to 50 ppm of the total mass (400 g) was added thereto, and they were stirred. Then, while the stirring was performed, a mixture was heated up to 130°C and subjected to ring-opening polymerization for 6 hours.

After the finish of the ring-opening polymerization, the mixture was sufficiently cooled, and then 1 g of trimethylsilylchloride was added thereto and sufficiently stirred to deactivate the potassium hydroxide. Thus, an intermediate product CC was obtained. Then, xylene was added thereto to dilute the intermediate product CC so that its concentration of a resin content became 60% or less, then a solution made by dissolving 5 g of NaCl into 20 g of water (hereinafter, referred to as a water/NaCl solution) was added to a diluted solution, and they were heated, whereby deoxidation was performed. After a mixed solution of a xylene solution of the intermediate product CC and the water/NaCl solution reached 60°C or higher, the stirring was stopped for liquid separation. The xylene solution of the intermediate product CC being an upper layer was fractionated, then a 20g/20g/5g solution of water/methanol/NaCl was added to the fractionated solution, and heating and washing were performed. By this operation, a volatile low-molecular siloxane having a number of D units contained in the xylene solution of the intermediate product CC of 20 or less was extracted and removed.

After the mixed solution of the xylene solution of the intermediate product CC and the water/methanol/NaCl solution reached 60°C or higher, the stirring was stopped for liquid separation, and the xylene solution of the intermediate product CC being the upper layer was fractionated. Since the fractionated xylene solution of the intermediate product CC contained small amounts of methanol and water together with the volatile low-molecular siloxane having a number of D units of 20 or less, a 20g/5g solution of water/NaCl was further added, and heating and washing were performed. Then, after the mixed solution reached 60°C or higher, the stirring was stopped for liquid separation. The xylene solution of the intermediate product CC being the upper layer was fractionated, and then the fractionated solution was subjected to heating reflux, whereby dehydration was performed. Subsequently, the solution was subjected to cooling, then filtration, and removal of solvent by heating under reduced pressure. Thus, the polymethylsiloxane having vinyl groups at a terminal and a side chain being the intermediate product CC was obtained.

In the intermediate product CC thus obtained, the numbers of moles of the units calculated from the charged amounts result in that the D unit is 4.58 ((339.0/296) $\times$ 4), the $M^{vi}$ unit is 0.017 ((1.6/186) $\times$ 2), and the $D^{Vi}$ unit is 0.671 ((57.7/344) $\times$ 4), and the molar ratio is the D unit: the $M^{vi}$ unit: the $D^{Vi}$ unit = 539:2:79.

Accordingly, the obtained intermediate product CC is found to be the polymethylsiloxane having vinyl groups at terminals and a side chain represented by an average unit formula: $M^{vi}D_{539}D^{Vi}{}_{79}M^{vi}$.

Synthesis Example 7 [synthesis of a silicone resin A-1]

(First step)

200 g of xylene was added to 200 g of the intermediate product AA (silicone resin having a methoxy group) for dilution, a dilution was subjected to hydrolysis by adding 0.6 g of 50 mass% (referred to as 50%, the same applying to the following) cesium hydroxide solution and 50 g of water thereto and heating. In infrared absorption spectrum measurement, the reaction was continued until characteristic absorption coming to the methoxy group at a wave number of 2830 $cm^{-1}$ disappeared.

Thus, a cerium hydroxide-containing xylene solution of a silicone resin polymer having no methoxy group represented by an average unit formula: $(Me_2SiO_{2/2})_{34}(Ph_2SiO_{2/2})_{33}(PhSiO_{3/2})_{33}$ was obtained.

(Second step)

To 85 g of the resin content of a reaction product obtained in the first step, 10 g of polymethylsiloxane having vinyl groups at both terminals and a side chain (Vi amount of 1.73 mmol/g) being the intermediate product CC and 5 g of cyclic polymethylvinylsiloxane $(MeViSiO_{2/2})_4$ (Vi amount of 11.6 mmol/g) were added, and they were reacted at a xylene reflux temperature for 5 hours for graft polymerization and equilibrium. After cooling, 0.3 g of trimethylchlorosilane was added for neutralization, an operation (water-washing operation) of washing the xylene solution with water and removing a water layer by a liquid separation was performed. After the water layer was neutralized by repeating the water-washing operation, water remaining in a xylene layer was removed by subjecting the water and xylene to azeotropy. Thus, by filtrating the xylene layer after completion of dehydration and then distilling off xylene under reduced pressure, a silicone resin A-1 was obtained.

The silicone resin A-1 was obtained by reacting an organosiloxane G represented by an average unit formula: $(Me_2SiO_{2/2})_{34}(Ph_2SiO_{2/2})_{33}(PhSiO_{3/2})_{33}$, a polymethylsiloxane H having vinyl groups at both terminals and a side chain represented by a formula: $M^{vi}D_{539}D^{vi}{}_{79}M^{vi}$, and an organosiloxane I represented by a formula:
$(MeViSiO_{2/2})_4$ at a mass ratio (%) of G:H:I = 85:10:5 in terms of charge amount.

In the second step, the polymethylsiloxane having vinyl groups at both terminals and a side chain and the cyclic methylvinylsiloxane were split and graft-polymerized with the reaction product obtained in the first step, whereby the

silicone resin A-1 was obtained.

The copolymerization composition ratio of the obtained silicone resin A-1 was measured by using deuterochloroform as a solvent and using $^1$H-NMR (manufactured by BRUKER Corporation, apparatus name; ARX-400). As a result of the measurement, it was found that the silicone resin A-1 was represented by an average composition formula: $T^{Ph}_{25.42}D^{Ph2}_{25.42}D_{40.07}D^{Vi}_{9.04}M^{Vi}_{0.05}$.

The silicone resin A-1 had a viscosity of 140 Pa·s, a nonvolatile content measured after heated at 150°C for 1 hour of 99.1 mass% (hereinafter, referred to as %, and meaning a weight loss on heating of 1.0%), an Mw of 2240, and a degree of dispersion (Mw/Mn) of 2.018. Note that the number of vinyl groups per molecule in the silicone resin A-1 is 1.7 on average from the value of Mw.

Synthesis Example 8 [synthesis of a silicone resin A-2]

(First Step)

300g of xylene was added to 300 g of the intermediate product AA (silicone resin having a methoxy group) for dilution, and a dilution was subjected to hydrolysis by adding 0.7 g of 50% cesium hydroxide solution and 200 g of water thereto and heating. In infrared absorption spectrum measurement, the reaction was continued until characteristic absorption coming to the methoxy group at a wave number of 2830 $cm^{-1}$ disappeared.

(Second Step)

To 85 g of the resin content of a reaction product obtained in the first step, 5 g of polymethylsiloxane having vinyl groups at both terminals and a side chain (Vi amount of 1.73 mmol/g) being the intermediate product CC and 10 g of cyclic polymethylvinylsiloxane $(MeViSiO_{2/2})_4$ (Vi amount of 11.6 mmol/g) were added, and they were reacted at a xylene reflux temperature for 5 hours for graft polymerization and equilibrium. After cooling, 0.5 g of trimethylchlorosilane was added for neutralization, an operation (water-washing operation) of washing the xylene solution with water and removing a water layer by a liquid separation was performed. After the water layer was neutralized by repeating the water-washing operation, water remaining in a xylene layer was removed by subjecting the water and xylene to azeotropy. Thus, by filtrating the xylene layer after completion of dehydration and then distilling off xylene under reduced pressure, a silicone resin A-2 was obtained.

The silicone resin A-2 was obtained by reacting an organosiloxane G represented by an average unit formula: $(Me_2SiO_{2/2})_{34}(Ph_2SiO_{2/2})_{33}(PhSiO_{3/2})_{33}$, a polymethylsiloxane H having vinyl groups at both terminals and a side chain represented by a formula: $M^{vi}D_{539}D^{Vi}_{79}M^{vi}$, and an organosiloxane I represented by a formula: $(MeViSiO_{2/2})_4$ at a mass ratio (%) of G:H:I = 85:5:10 in terms of charge amount.

In the second step, the polymethylsiloxane being the silicone resin CC having vinyl groups at both terminals and a side chain and the cyclic methylvinylsiloxane were split and graft-polymerized with the reaction product obtained in the first step, whereby the silicone resin A-2 was obtained.

As a result of the measurement of the copolymerization composition ratio of the obtained silicone resin A-2 as in Synthesis Example 7, it was found that the silicone resin A-2 was represented by an average composition formula: $T^{Ph}_{25.67}D^{Ph2}_{25.67}D_{33.45}D^{Vi}_{15.18}M^{Vi}_{0.03}$.

The silicone resin A-2 had a viscosity of 259 Pa·s, a nonvolatile content measured after heated at 150°C for 1 hour of 99.6 %, an Mw of 2970, and a degree of dispersion (Mw/Mn) of 2.244. Note that the number of vinyl groups per molecule in the silicone resin A-2 is 3.7 on average from the Mw.

Synthesis Example 9 [synthesis of a silicone resin A-3]

(First Step)

200g of xylene was added to 200 g of the intermediate product BB for dilution, and a dilution was subjected to hydrolysis by adding 0.6 g of 50% cesium hydroxide solution and 50 g of water thereto and heating. In infrared absorption spectrum measurement, the reaction was continued until characteristic absorption coming to the methoxy group at a wave number of 2830 $cm^{-1}$ disappeared.

Thus, a cerium hydroxide-containing xylene solution of a silicone resin polymer having no methoxy group represented by an average unit formula: $(Me_2SiO_{2/2})_{20}(Ph_2SiO_{2/2})_{20}(PhSiO_{3/2})_{60}$ was obtained.

(Second Step)

To 85 g of the resin content of a reaction product obtained in the first step, 5 g of polymethylsiloxane having vinyl groups at both terminals and a side chain (Vi amount of 1.73 mmol/g) being the intermediate product CC and 10 g of cyclic

polymethylvinylsiloxane $(MeViSiO_{2/2})_4$ (Vi amount of 11.6 mmol/g) were added, and they were reacted at a xylene reflux temperature for 5 hours for graft polymerization and equilibrium. After cooling, 0.3 g of trimethylchlorosilane was added for neutralization, an operation (water-washing operation) of washing the xylene solution with water and removing a water layer by a liquid separation was performed. After the water layer was neutralized by repeating the water-washing operation, water remaining in a xylene layer was removed by subjecting the water and xylene to azeotropy. Thus, by filtrating the xylene layer after completion of dehydration and then distilling off xylene under reduced pressure, a silicone resin A-3 was obtained.

The silicone resin A-3 was obtained by reacting an organosiloxane G represented by an average unit formula: $(Me_2SiO_{2/2})_{20}(Ph_2SiO_{2/2})_{20}(PhSiO_{3/2})_{60}$, a polymethylsiloxane H having vinyl groups at both terminals and a side chain represented by a formula: $M^{vi}D_{539}D^{vi}{}_{79}M^{vi}$, and an organosiloxane I represented by a formula: $(MeViSiO_{2/2})_4$ at a mass ratio (%) of G:H:I = 85:5:10 in terms of charge amount.

In the second step, the polymethylsiloxane having vinyl groups at both terminals and a side chain and the cyclic methylvinylsiloxane were split and graft-polymerized with the reaction product obtained in the first step, whereby the silicone resin A-3 was obtained.

As a result of the measurement of the copolymerization composition ratio of the obtained silicone resin A-3 as in Synthesis Example 7, it was found that the silicone resin A-3 was represented by an average composition formula: $T^{Ph}{}_{46.77}D^{Ph2}{}_{15.59}D_{22.54}D^{Vi}{}_{15.07}M^{Vi}{}_{0.03}$.

The silicone resin A-3 was a solid at normal temperature and had a nonvolatile content measured after heated at 150°C for 1 hour of 99.8 %, an Mw of 2458, and a degree of dispersion (Mw/Mn) of 1.940. Note that the number of vinyl groups per molecule in the silicone resin A-3 is 3.1 on average from the Mw.

Synthesis Example 10 [synthesis of a silicone resin A-4]

(First Step)

200g of xylene was added to 200 g of the intermediate product BB for dilution, and a dilution was subjected to hydrolysis by adding 0.6 g of cesium hydroxide solution with a concentration of 50% and 50 g of water thereto and heating. In infrared absorption spectrum measurement, the reaction was continued until characteristic absorption coming to the methoxy group at a wave number of 2830 $cm^{-1}$ disappeared.

Thus, a cerium hydroxide-containing xylene solution of a silicone resin polymer having no methoxy group represented by an average unit formula: $(Me_2SiO_{2/2})_{20}(Ph_2SiO_{2/2})_{20}(PhSiO_{3/2})_{60}$ was obtained.

(Second Step)

To 76.5 g of the resin content of a reaction product obtained in the first step, 14.5 g of polymethylsiloxane having vinyl groups at both terminals and a side chain (Vi amount of 1.73 mmol/g) being the intermediate product CC and 9 g of cyclic polymethylvinylsiloxane $(MeViSiO_{2/2})_4$ (Vi amount of 11.6 mmol/g) were added, and they were reacted at a xylene reflux temperature for 5 hours for graft polymerization and equilibrium. After cooling, 0.3 g of trimethylchlorosilane was added for neutralization, an operation (water-washing operation) of washing the xylene solution with water and removing a water layer by a liquid separation was performed. After the water layer was neutralized by repeating the water-washing operation, water remaining in a xylene layer was removed by subjecting the water and xylene to azeotropy. Thus, by filtrating the xylene layer after completion of dehydration and then distilling off xylene under reduced pressure, a silicone resin A-4 was obtained.

The silicone resin A-4 was obtained by reacting an organosiloxane G represented by an average unit formula: $(Me_2SiO_{2/2})_{20}(Ph_2SiO_{2/2})_{20}(PhSiO_{3/2})_{60}$, a polymethylsiloxane H having vinyl groups at both terminals and a side chain represented by a formula: $M^{vi}D_{539}D^{Vi}{}_{79}M^{vi}$, and an organosiloxane I represented by a formula: $(MeViSiO_{2/2})_4$ at a mass ratio (%) of G:H:I = 76.5:14.5:9 in terms of charge amount.

In the second step, the polymethylsiloxane having vinyl groups at both terminals and a side chain being the intermediate product CC and the cyclic methylvinylsiloxane were split and graft-polymerized with the reaction product obtained in the first step, whereby the silicone resin A-4 was obtained.

As a result of the measurement of the copolymerization composition ratio of the obtained silicone resin A-4 as in Synthesis Example 7, it was found that the silicone resin A-4 was represented by an average composition formula: $T^{Ph}{}_{39.71}D^{Ph2}{}_{13.24}D_{32.27}D^{Vi}{}_{14.71}M^{Vi}{}_{0.07}$.

The silicone resin A-4 had a viscosity of 30 Pa·s, a nonvolatile content measured after heated at 150°C for 1 hour of 99.0 %, an Mw of 2143, and a degree of dispersion (Mw/Mn) of 1.710. Note that the number of vinyl groups per molecule in the silicone resin A-4 is 2.8 on average from the Mw.

Synthesis Example 11 [synthesis of a silicone resin A-5]

(First Step)

200g of xylene was added to 200 g of the intermediate product BB for dilution, and a dilution was subjected to hydrolysis by adding 0.6 g of 50% cesium hydroxide solution and 50 g of water thereto and heating. In infrared absorption spectrum measurement, the reaction was continued until characteristic absorption coming to the methoxy group at a wave number of 2830 $cm^{-1}$ disappeared.

Thus, a cerium hydroxide-containing xylene solution of a silicone resin polymer having no methoxy group represented by an average unit formula: $(Me_2SiO_{2/2})_{20}(Ph_2SiO_{2/2})_{20}(PhSiO_{3/2})_{60}$ was obtained.

(Second Step)

To 85 g of the resin content of a reaction product obtained in the first step, 10 g of polymethylsiloxane having vinyl groups at both terminals and a side chain (Vi amount of 1.73 mmol/g) being the intermediate product CC and 5 g of cyclic polymethylvinylsiloxane $(MeViSiO_{2/2})_4$ (Vi amount of 11.6 mmol/g) were added, and they were reacted at a xylene reflux temperature for 5 hours for graft polymerization and equilibrium. After cooling, 0.3 g of trimethylchlorosilane was added for neutralization, an operation (water-washing operation) of washing the xylene solution with water and removing a water layer by a liquid separation was performed. After the water layer was neutralized by repeating the water-washing operation, water remaining in a xylene layer was removed by subjecting the water and xylene to azeotropy. Thus, by filtrating the xylene layer after completion of dehydration and then distilling off xylene under reduced pressure, a silicone resin A-5 was obtained.

The silicone resin A-5 was obtained by reacting an organosiloxane G represented by an average unit formula: $(Me_2SiO_{2/2})_{20}(Ph_2SiO_{2/2})_{20}(PhSiO_{3/2})_{60}$, a polymethylsiloxane H having vinyl groups at both terminals and a side chain represented by a formula: $M^{vi}D_{539}D^{Vi}_{79}M^{vi}$, and an organosiloxane I represented by a formula: $(MeViSiO_{2/2})_4$ at a mass ratio (%) of G:H:I = 85:10:5 in terms of charge amount.

In the second step, the polymethylsiloxane having vinyl groups at both terminals and a side chain and the cyclic methylvinylsiloxane were split and graft-polymerized with the reaction product obtained in the first step, whereby the silicone resin A-5 was obtained.

As a result of the measurement of the copolymerization composition ratio of the obtained silicone resin A-5 as in Synthesis Example 7, it was found that the silicone resin A-5 was represented by an average composition formula: $T^{Ph}_{46.32}D^{Ph2}_{15.44}D_{29.21}D^{Vi}_{8.97}M^{Vi}_{0.05}$.

The silicone resin A-5 had a viscosity of 291 Pa·s, a nonvolatile content measured after heated at 150°C for 1 hour of 99.7 %, an Mw of 2151, and a degree of dispersion (Mw/Mn) of 1.717. Note that the number of vinyl groups per molecule in the silicone resin A-5 is 1.6 on average from the Mw.

Synthesis Example 12 [synthesis of a polyorganohydrogensiloxane B3]

402 g (3 mol) of tetramethyldisiloxane, 100 g of concentrated hydrochloric acid, 240 g of ion-exchange water, and 200 g of ethanol were charged into a reaction container and cooled to 15°C or lower while being stirred. After completion of the cooling, 793 g (4 mol) of phenyltrimethoxysilane was dripped at a rate of 250 g/hour. The cooling was continued to prevent the temperature of the reaction mixture from exceeding 15°C since heat generation was started with hydrolysis.

After finish of the dripping of phenyltrimethoxysilane, the hydrolysis was continued for 4 hours, and then 918 g of xylene was added thereto to dilute. A dilution was stirred for 1 hour after the dilution, and then left standing still for liquid separation. Its upper layer was a xylene solution of the polyorganohydrogensiloxane. 200 g of ion-exchange water was added to a fractionated xylene solution, a mixture was subjected to heating and water-washing, and then left standing still again for liquid separation.

100 g of methanol and 100 g of ion-exchange water were added to the upper layer, and a mixture was subjected again to heating and water-washing and then left standing still for liquid separation. Next, the liquid at the upper layer was subjected to heating reflux to remove remaining ion-exchange water and methanol, and then filtration and removal of solvent and concentration under reduced pressure. Finally, by heating the liquid up to 150°C while introducing nitrogen, and removing the solvent and a volatile fraction while adjusting the degree of pressure reduction into a range of 1 to 50 mmH using a vacuum pump, 785 g of polyorganohydrogensiloxane B2 was obtained.

From the amounts of charged components, the effective hydrogen amount, and measurement result of gas chromatography, the obtained polyorganohydrogensiloxane B3 was found to be polyphenylhydrogensiloxane having a branch structure represented by a formula: $M^{H}_{6}T^{Ph}_{4}$.

The Mw of the polyorganohydrogensiloxane B3 was 918, and the actual measured hydrogen content was 0.668 % relative to the theoretical hydrogen content of 0.654%.

Synthesis Example 13 [synthesis of (E) alkoxy group -containing isocyanurate]

64 g of 1,3,5-triallylisocyanurate (manufactured by Nippon Kasei Chemical Co., Ltd., brand name; TAIC) and 34 g of methyldimethoxysilane were subjected to a hydrosilylation reaction for 2 hours in the presence of a catalytic amount of a Pt catalyst. Thus, a mixture of an isocyanuric acid derivative having one methyldimethoxysilyl group and two vinyl groups represented by [Chemical Formula 6] and an isocyanuric acid derivative having two methyldimethoxysilyl groups and one vinyl group represented by [Chemical Formula 7] was obtained.

[Chemical Formula 6]

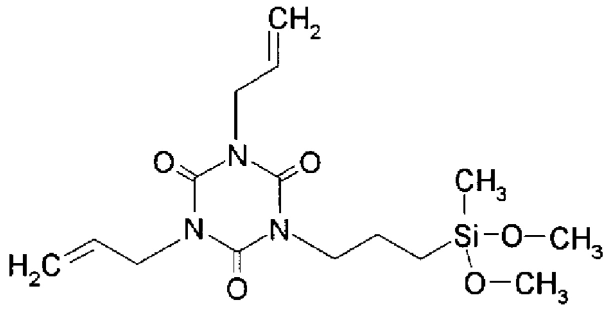

[Chemical Formula 7]

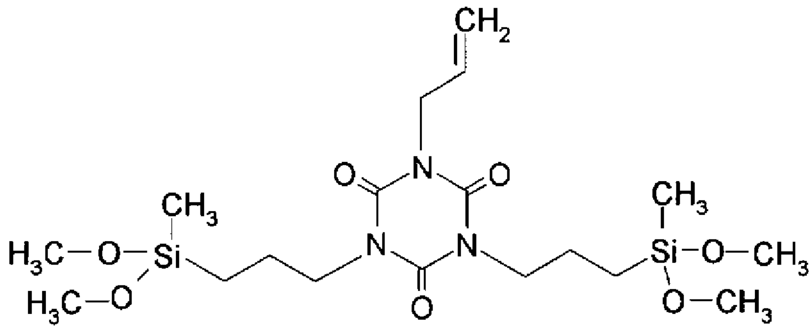

Example 7

In a mixture of 50 parts of the silicone resin A-1 obtained in Synthesis Example 7 (the polyorganosiloxane represented by an average composition formula: $T^{Ph}_{25.42}D^{Ph2}_{25.42}D_{40.07}D^{Vi}_{9.04}M^{Vi}_{0.05}$) and 50 parts of the silicone resin A-2 obtained in Synthesis Example 8 (the polyorganosiloxane represented by an average composition formula: $T^{Ph}_{25.67}D^{Ph2}_{25.67}D_{33.45}D^{Vi}_{0.03}$), 19.1 parts of the polyorganohydrogensiloxane B3 obtained in Synthesis Example 12, represented by a unit formula: $M^{H}_{6}T^{ph}_{4}$ (the mol (equivalent weight) ratio of the SiH groups in the (B) component relative to the vinyl groups in the (A) component (H/Vi) = 1.28), (C) 0.02 parts of a platinum complex solution having tetramethyltetravinylcyclotetrasiloxane as a ligand (Pt content of 1.8 %), and 1.1 parts of the adhesiveness imparting agent D1 obtained in Synthesis Example 1 represented by a unit formula: $T^{ep}_{15}T_{25}D_{55}D^{vi}_{5}(OMe)_{15}$ were added and kneaded, whereby a polyorganosiloxane composition was obtained.

Examples 8 to 25

By compounding the components listed in Table 3 and Table 4 at ratios listed in the same tables, polyorganosiloxane compositions were obtained as in Example 7.

Note that the H-Vi ratio in Table 3 and Table 4 indicates the molar ratio between hydrogen atoms bonded to silicon atoms in the (B) component and vinyl groups bonded to silicon atoms in the (A) component.

Further, the components are as follows.

Silicone resin A-3 ...... polyorganosiloxane obtained in Synthesis Example 9, represented by an average composition formula: $T^{Ph}_{46.77}D^{Ph2}_{15.59}D_{22.54}D^{Vi}_{15.07}M^{Vi}_{0.03}$

Silicone resin A-4 ...... polyorganosiloxane obtained in Synthesis Example 10, represented by an average composition formula: $T^{Ph}_{39.71}D^{Ph2}_{13.24}D_{32.27}D^{Vi}_{14.71}M^{Vi}_{0.07}$
Silicone resin A-5 ...... polyorganosiloxane obtained in Synthesis Example 11, represented by an average composition formula: $T^{Ph}_{46.32}D^{Ph2}_{15.44}D_{29.21}D^{Vi}_{8.97}M^{Vi}_{0.05}$
Polyorganohydrogensiloxane B4 ...... diphenylhydrogensiloxane represented by a unit formula: $M^{H}D^{Ph2}M^{H}$
Adhesiveness imparting agent D6 ...... adhesiveness imparting agent obtained in Synthesis Example 6, represented by a unit formula: $T^{ep}_{15}T_{25}D^{Ph}_{30}D_{25}D^{vi}_{5}(OMe)_{15}$

Comparative Examples 3 to 5

By compounding the components listed in Table 5 at ratios listed in the same table, polyorganosiloxane compositions were obtained as in Example 7.

Note that the SiH group-containing adhesiveness imparting agent in Table 5 is a 1:2 addition reaction product of a SiH group-containing siloxane oligomer represented by

[Chemical Formula 8]

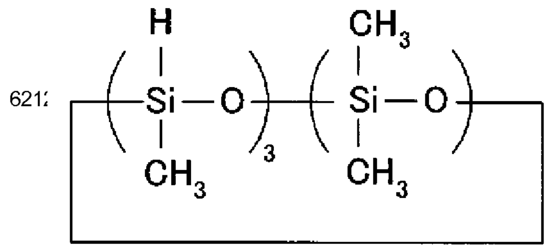

and γ-methacryloxypropyltrimethoxysilane. Further, as the γ-glycidoxypropyltrimethoxysilane, TSL8350 (brand name of Momentive) was used. An H/Vi ratio in Table 5 indicates the molar ratio between hydrogen atoms bonded to silicon atoms in the (B) component and vinyl groups bonded to silicon atoms in the (A) component.

The viscosities and refractive indexes of the polyorganosiloxane compositions thus obtained in Examples 7 to 25 and Comparative Examples 3 to 5 were measured as follows. Further, after the polyorganosiloxane compositions obtained in Examples 7 to 25 and Comparative Examples 3 to 5 were heated at 150°Cfor 3 hours and thereby cured, physical properties (hardness, tensile strength, elongation, and transmittance) of cured products were measured in conformity to JIS K 6253 "Testing methods for uncured and cured silicones rubber" and so on. In addition, a package test (2) was performed as follows to investigate adhesiveness to the base material made of the PPA resin. The results of the measurement and test are listed in low columns in Tables 3 to 5.

[Viscosity]

The viscosity of the polyorganosiloxane composition before curing was measured using a rotational viscometer at 23°C±2°C.

[Refractive index]

Regarding the polyorganosiloxane composition before curing, the refractive index of a sodium D line (wavelength of 589 nm) was measured using a multi-wavelength Abbe refractometer (manufactured by Atago Co., Ltd., apparatus name; DR-M2/1550). The measurement was performed at 25°C.

[Package test (2)]

(Presence or absence of peeling from PPA)

After a 3528-type LED package was dried at 150°C for 2 hours, the sample of the polyorganosiloxane composition was filled in a base material made of a PPA resin (Kuraray Co., Ltd, brand name; Genestar) using a syringe. Then, the sample was heated at 100°C for 2 hours and then heated at 150 °C for 3 hours and thereby cured. The presence or absence of peeling of the cured product from the PPA resin was investigated using a microscope (60 to 80 magnifications). The number of samples (n) was 10, and the number of samples where peeling was observed was

counted.

Further, for the polyorganosiloxane compositions obtained in Examples 17 to 25, the packaged test (2) was performed, and then the test described below was performed to investigate peeling after MSL3 reflow.

(Peeling after MSL3 reflow)

Using an LED package in which the sample was filled and cured, used for the peeling test from the PPA, the MSL3 test in conformity to IPC/JEDEC J-STD-020D.1 was performed. In this test, the LED package in which the sample had been filled and cured was dried at 125°C for 24 hours, and then left as it was for 40 hours in a chamber at 60°C/60%RH under a condition of Level 3 and made to absorb moisture. After the moisture absorption, the LED package was left as it was at room temperature for 15 minutes, and put into a reflow oven at a maximum of 260°C (about 5 minutes for one cycle). After cooling at room temperature for 5 minutes, the LED package was put again into the reflow oven, and this cycle was repeated three times in total. Then, the LED package was cooled to room temperature, and the presence or absence of peeling of the cured product from the PPA resin was investigated using a microscope (60 to 80 magnifications). Then, the number of samples where peeling was observed in ten samples was counted.

[Table 3]

| | | | Exam. 7 | Exam. 8 | Exam. 9 | Exam. 10 | Exam. 11 | Exam. 12 | Exam. 13 | Exam. 14 | Exam. 15 | Exam. 16 |
|---|---|---|---|---|---|---|---|---|---|---|---|---|
| Composition (Parts by Mass) | (A) | Silicone Resin A-1 | 50 | 50 | 40 | 40 | 40 | 40 | 50 | 50 | 60 | 40 |
| | | Silicone Resin A-2 | 50 | 50 | 60 | 60 | 60 | 60 | 50 | 50 | | |
| | | Silicone Resin A-3 | | | | | | | | | 40 | 30 |
| | | Silicone Resin A-4 | | | | | | | | | | 30 |
| | | Silicone Resin A-5 | | | | | | | | | | |
| | (B) | Phenyl Group-containing Polyorganohydrogensiloxane B3 | 19.1 | 19.1 | 19.7 | 15.7 | 12.6 | 12.4 | 16.5 | 9.3 | 8.5 | 17.5 |
| | | Phenyl Group-containing Polyorganohydrogensiloxane B4 | | | | | | 8.0 | | 8.0 | 8.0 | |
| | (C) | Pt-based Catalyst | 0.02 | 0.02 | 0.02 | 0.02 | 0.02 | 0.02 | 0.02 | 0.02 | 0.02 | 0.02 |
| | (D) | Adhesiveness Imparting Agent D1 | 1.1 | | 1.1 | 1.1 | 1.1 | 1.1 | 1.1 | 1.1 | 1.1 | 1.1 |
| | | Adhesiveness Imparting Agent D6 | | 1.1 | | | | | | | | |
| | | SiH Group-containing Adhesiveness Imparting Agent | | | | | | | | | | |
| | | γ-glycidoxypropyltrimethoxysilane | | | | | | | | | | |
| | (E) | Alkoxy Group-containing Isocyanurate | | | 1.0 | 1.0 | 1.0 | 1.0 | 1.0 | 1.0 | 1.0 | 1.0 |
| H/Vi ((A) and (B)) | | | 1.28 | 1.28 | 1.25 | 1.00 | 0.80 | 1.25 | 1.10 | 1.10 | 1.10 | 1.10 |

(continued)

| | | | Exam. 7 | Exam. 8 | Exam. 9 | Exam. 10 | Exam. 11 | Exam. 12 | Exam. 13 | Exam. 14 | Exam. 15 | Exam. 16 |
|---|---|---|---|---|---|---|---|---|---|---|---|---|
| Characteristics | Characteristics Before Curing | Viscosity (23±2°C) (Pa·s) | 14.4 | 10.8 | 6.6 | 12.7 | 20.4 | 5.3 | 17.2 | 9.8 | 11.8 | 12.5 |
| | | Refractive Index ($n_D^{25}$) | 1.54 | 1.54 | 1.53 | 1.54 | 1.54 | 1.53 | 1.54 | 1.54 | 1.54 | 1.53 |
| | Characteristics After Curing | Hardness (Type D) | 44 | 37 | 35 | 26 | 14 | 25 | 43 | 28 | 30 | 43 |
| | | Tensile Strength (MPa) | 4.4 | 3.2 | 2.7 | 2.3 | 0.7 | 1.7 | 4.3 | 2.4 | 2.5 | 4.9 |
| | | Elongation (%) | 40 | 50 | 40 | 60 | 60 | 60 | 50 | 70 | 80 | 50 |
| | | Transmittance (%) (2 mm), 400 nm | 96 | 98 | 98 | 97 | 96 | 97 | 95 | 96 | 97 | 98 |
| | PKG Test (2) | Number of Peelings from PPA | 0/10 | 0/10 | 0/10 | 0/10 | 0/10 | 0/10 | 0/10 | 0/10 | 0/10 | 0/10 |
| | | Number of Peelings from PPA after MSL3 Reflow | - | - | - | - | - | - | - | - | - | - |
| Exam. 7 to Exam. 16 = Example 7 to Example 16 | | | | | | | | | | | | |

[Table 4]

| | | | Exam. 17 | Exam. 18 | Exam. 19 | Exam. 20 | Exam. 21 | Exam. 22 | Exam. 23 | Exam. 24 | Exam. 25 |
|---|---|---|---|---|---|---|---|---|---|---|---|
| Composition (Parts by Mass) | (A) | Silicone Resin A-1 | 40 | 40 | 40 | 40 | 40 | 40 | | | |
| | | Silicone Resin A-2 | | | | | | | | | |
| | | Silicone Resin A-3 | 30 | 30 | 30 | 30 | 30 | 30 | 30 | 10 | 10 |
| | | Silicone Resin A-4 | 30 | 30 | 30 | 30 | 30 | 30 | 30 | 30 | 30 |
| | | Silicone Resin A-5 | | | | | | | 40 | 60 | 60 |
| | (B) | Phenyl Group-containing Polyorganohydrogensiloxane B3 | 10.3 | 10.3 | 10.3 | 10.3 | 10.3 | 10.3 | 10.3 | 8.7 | 7.2 |
| | | Phenyl Group-containing Polyorganohydrogensiloxane B4 | 8.0 | 8.0 | 8.0 | 8.0 | 8.0 | 8.0 | 8.0 | 8.0 | 8.0 |
| | (C) | Pt-based Catalyst | 0.02 | 0.02 | 0.02 | 0.02 | 0.02 | 0.02 | 0.02 | 0.02 | 0.02 |
| | (D) | Adhesiveness Imparting Agent D1 | 1.1 | 1.1 | 2.3 | 2.3 | 3.5 | 3.5 | 1.1 | 1.1 | 1.1 |
| | | Adhesiveness Imparting Agent D6 | | | | | | | | | |
| | | SiH Group-containing Adhesiveness Imparting Agent | | | | | | | | | |
| | | γ-glycidoxypropyltrimethoxysilane | | | | | | | | | |
| | (E) | Alkoxy Group-containing Isocyanurate | 1.0 | 2.0 | | 1.0 | | 1.0 | 1.0 | 1.0 | 1.0 |
| H/Vi ((A) and (B)) | | | 1.10 | 1.10 | 1.10 | 1.10 | 1.10 | 1.10 | 1.10 | 1.10 | 1.00 |

(continued)

| | | | Exam. 17 | Exam. 18 | Exam. 19 | Exam. 20 | Exam. 21 | Exam. 22 | Exam. 23 | Exam. 24 | Exam. 25 |
|---|---|---|---|---|---|---|---|---|---|---|---|
| Characteristics | Characteristics Before Curing | Viscosity (23±2°C) (Pa·s) | 6.4 | 6.4 | 6.7 | 6.6 | 7.4 | 6.4 | 8.7 | 8.4 | 10.2 |
| | | Refractive Index ($n_D^{25}$) | 1.53 | 1.53 | 1.53 | 1.53 | 1.53 | 1.53 | 1.53 | 1.53 | 1.53 |
| | Characteristics After Curing | Hardness (Type D) | 30 | 29 | 32 | 29 | 31 | 27 | 40 | 33 | 26 |
| | | Tensile Strength (MPa) | 2.7 | 2.1 | 2.4 | 2.3 | 2.3 | 2.1 | 4.1 | 2.6 | 0.9 |
| | | Elongation (%) | 70 | 70 | 60 | 70 | 60 | 60 | 70 | 90 | 80 |
| | | Transmittance (%) (2 mm), 400 nm | 98 | 97 | 97 | 97 | 96 | 96 | 98 | 98 | 98 |
| | PKG Test (2) | Number of Peelings from PPA | 0/10 | 0/10 | 0/10 | 0/10 | 0/10 | 0/10 | 0/10 | 0/10 | 0/10 |
| | | Number of Peelings from PPA after MSL3 Reflow | 0/10 | 0/10 | 0/10 | 0/10 | 0/10 | 0/10 | 0/10 | 0/10 | 0/10 |
| Exam. 17 to Exam. 25 = Example 17 to Example 25 | | | | | | | | | | | |

[Table 5]

| | | | C.E. 3 | C.E. 4 | C.E. 5 |
|---|---|---|---|---|---|
| Composition (Parts by Mass) | (A) | Silicone Resin A-1 | 50 | 40 | 50 |
| | | Silicone Resin A-2 | 50 | 60 | 50 |
| | | Silicone Resin A-3 | | | |
| | | Silicone Resin A-4 | | | |
| | | Silicone Resin A-5 | | | |
| | (B) | Phenyl Group-containing Polyorganohydrogensiloxane B3 | 19.1 | 20.1 | 19.1 |
| | | Phenyl Group-containing Polyorganohydrogensiloxane B4 | | | |
| | (C) | Pt-based Catalyst | 0.02 | 0.02 | 0.02 |
| | (D) | Adhesiveness Imparting Agent D1 | | | |
| | | Adhesiveness Imparting Agent D6 | | | |
| | | SiH Group-containing Adhesiveness Imparting Agent | | 0.9 | 1.5 |
| | | $\gamma$-glycidoxypropyltrimethoxysilane | | 0.3 | 0.5 |
| | (E) | Alkoxy Group-containing Isocyanurate | | | |
| H/Vi ((A) and (B)) | | | 1.28 | 1.28 | 1.28 |
| Characteristics | Characteristics Before Curing | Viscosity (23$\pm$2°C) (Pa·s) | 9.7 | 9.6 | 9.1 |
| | | Refractive Index ($n_D^{25}$) | 1.53 | 1.53 | 1.53 |
| | Characteristics After Curing | Hardness (Type D) | 27 | 35 | 31 |
| | | Tensile Strength (MPa) | 2.1 | 2.5 | 2.7 |
| | | Elongation (%) | 40 | 50 | 40 |
| | | Transmittance (%), (2 mm), 400 nm | 97 | 97 | 97 |
| | PKG Test (2) | Number of Peelings from PPA | 10/10 | 6/10 | 5/10 |
| | | Number of Peelings from PPA after MSL3 Reflow | - | - | - |
| C. E. 3 to C. E. 5 = Comparative Example 3 to Comparative Example 5 | | | | | |

From Tables 3 to 5, the following is found. The polyorganosiloxane compositions in Examples 7 to 25 each obtained by compounding the adhesiveness imparting agent D1 or D6 which contains the $T^{ep}$ unit having an epoxy group and the $D^{vi}$ unit having a vinyl group and has an Mw in a range of 1000 to 15000, in an addition reaction type polyorganosiloxane composition including a polyorganosiloxane containing a trifunctional siloxane unit having a phenyl group ($T^{Ph}$ unit) and a vinyl group, as a base polymer, are excellent in adhesiveness to PPA as compared with the polyorganosiloxane composition in Comparative Example 3 in which the adhesiveness imparting agent is not compounded, and the polyorganosiloxane compositions in Comparative Examples 4 to 5 in which $\gamma$-glycidoxypropyltrimethoxysilane or the like is compounded as the adhesiveness imparting agent. Specifically, the sealing layers composed of the cured products of the polyorganosiloxane compositions in Comparative Examples 3 to 5 have peeling occurred on the boundary face with the base material made of PPA, whereas the sealing layers composed of the cured products of the polyorganosiloxane compositions in Examples 7 to 25 have no peeling observed thereon and therefore exhibit excellent adhesiveness to PPA.

In particular, the polyorganosiloxane compositions obtained in Examples 17 to 25, in which the silicone resins A-3 to A-5 high in content ratio of the $T^{Ph}$ unit are used as the (A) component, exhibit high reliability also for the peeling test after the MSL3 reflow.

INDUSTRIAL APPLICABILITY

The adhesive polyorganosiloxane composition in which the adhesiveness imparting agent of the present invention is compounded exhibits excellent adhesiveness to heat-resistant plastic such as PPA, and never decreases in adhesiveness due to heat generation from a light emitting element or heating in a temperature cycle, or the like. Accordingly, the adhesive polyorganosiloxane composition of the present invention is high in reliability as a sealing material for a semiconductor device such as an LED device or the like and useful.

## Claims

**1.** An adhesiveness imparting agent, comprising a polyorganosiloxane,

the polyorganosiloxane containing:

(a) a trifunctional siloxane unit having an epoxy group and represented by a formula: $R^1SiO_{3/2}$, where $R^1$ represents an epoxyalkyl group or a glycidoxyalkyl group;
(b) a bifunctional siloxane unit having an alkenyl group represented by a formula: $R^3{}_2SiO_{2/2}$, where $R^3$ represents a monovalent hydrocarbon group selected from a group consisting of an alkenyl group and an alkyl group, and at least one $R^3$ is an alkenyl group;

a trifunctional siloxane unit represented by a formula $R^4SiO_{3/2}$, where $R^4$ represents an alkyl group; and
a bifunctional siloxane unit represented by a formula $R^4{}_2SiO_{2/2}$, where $R^4$ represents an alkyl group,
the polyorganosiloxane having a weight-average molecular weight of 1000 to 15000, this molecular weight being measured using a gel permeation chromatography (GPC) apparatus as described in the description.

**2.** The adhesiveness imparting agent according to claim 1, wherein the (a) trifunctional siloxane unit having an epoxy group has a glycidoxyalkyl group bonded to a silicon atom.

**3.** An adhesive polyorganosiloxane composition, comprising:

(A) 100 parts by mass of a polyorganosiloxane having an alkenyl group bonded to a silicon atom;
(B) a polyorganohydrogensiloxane having a hydrogen atom bonded to a silicon atom in such an amount that an amount of the hydrogen atom in the component becomes 0.1 to 4.0 per alkenyl group in the (A) component;
(C) a catalytic amount of a platinum-based catalyst; and
(D) 0.05 to 10 parts by mass of the adhesiveness imparting agent according to claim 1 or 2.

**4.** The adhesive polyorganosiloxane composition according to claim 3, wherein the polyorganosiloxane being the (A) component comprises a trifunctional siloxane unit having an aryl group.

**5.** The adhesive polyorganosiloxane composition according to claim 4, wherein the (B) polyorganohydrogensiloxane is compounded in such an amount that an amount of the hydrogen atom in the component becomes 0.5 to 2.5 per alkenyl group in the (A) component.

**6.** The adhesive polyorganosiloxane composition according to claim 4 or 5, wherein the (A) component comprises a polyorganosiloxane containing a trifunctional siloxane unit represented by a formula: $C_6H_5SiO_{3/2}$ at a ratio of 20 to 60 mol% relative to all constitutional units.

**7.** The adhesive polyorganosiloxane composition according to any one of claims 4 to 6, wherein the (A) component comprises at least two kinds of polyorganosiloxanes which are a polyorganosiloxane containing a bifunctional siloxane unit represented by a formula: $CH_3(CH_2=CH)SiO_{2/2}$ at a ratio of 10 mol% or less relative to all constituent units, and a polyorganosiloxane containing the bifunctional siloxane unit represented by the formula: $CH_3(CH_2=CH)SiO_{2/2}$ at a ratio of more than 10 mol% relative to all constituent units.

**8.** The adhesive polyorganosiloxane composition according to claim 7, wherein the (A) component comprises a polyorganosiloxane containing a trifunctional siloxane unit represented by a formula: $C_6H_5SiO_{3/2}$ at a ratio of 30 to 55 mol% relative to all constitutional units.

9. The adhesive polyorganosiloxane composition according to any one of claims 4 to 8, wherein the (B) component comprises a branched polyorganohydrogensiloxane having a trifunctional siloxane unit represented by a formula: $C_6H_5SiO_{3/2}$.

10. The adhesive polyorganosiloxane composition according to any one of claims 4 to 9, wherein the (B) component comprises a polyorganohydrogensiloxane having hydrogen atoms bonded to silicon atoms at both molecular chain terminals respectively.

11. The adhesive polyorganosiloxane composition according to any one of claims 4 to 10, further comprising: (E) 0.05 to 5 parts by mass of an isocyanurate compound having an alkoxy group.

12. An optical semiconductor device comprising a cured product made by curing the adhesive polyorganosiloxane composition according to any one of claims 3 to 11.

13. The optical semiconductor device according to claim 12, wherein the cured product contains a phosphor.

## Patentansprüche

1. Haftvermögen verleihendes Mittel umfassend ein Polyorganosiloxan,

wobei das Polyorganosiloxan Folgendes enthält:

(a) eine trifunktionelle Siloxaneinheit, die eine Epoxygruppe aufweist und durch eine Formel: $R^1SiO_{3/2}$ dargestellt ist, wobei $R^1$ eine Epoxyalkylgruppe oder eine Glycidoxyalkylgruppe darstellt;
(b) eine bifunktionelle Siloxaneinheit, die eine Alkenylgruppe aufweist, die durch eine Formel: $R^3{}_2SiO_{2/2}$ dargestellt ist, wobei $R^3$ eine einwertige Kohlenwasserstoffgruppe darstellt, die aus einer Gruppe ausgewählt ist bestehend aus einer Alkenylgruppe und einer Alkylgruppe, und mindestens ein $R^3$ eine Alkenylgruppe ist;

eine trifunktionelle Siloxaneinheit, die durch eine Formel $R^4SiO_{3/2}$ dargestellt ist, wobei $R^4$ eine Alkylgruppe darstellt; und
eine bifunktionelle Siloxaneinheit, die durch eine Formel $R^4{}_2SiO_{2/2}$ dargestellt ist, wobei $R^4$ eine Alkylgruppe darstellt;
wobei das Polyorganosiloxan ein gewichtsdurchschnittliches Molekulargewicht von 1 000 bis 15 000 aufweist, wobei dieses Molekulargewicht unter Anwendung einer Gelpermeationschromatographie- (GPC-) Vorrichtung, wie in der Beschreibung beschrieben, gemessen wird.

2. Haftvermögen verleihendes Mittel nach Anspruch 1, wobei die (a) trifunktionelle Siloxaneinheit, die eine Epoxygruppe aufweist, eine Glycidoxyalkylgruppe aufweist, die an ein Siliciumatom gebunden ist.

3. Adhäsive Polyorganosiloxanzusammensetzung, umfassend:

(A) 100 Masseteile eines Polyorganosiloxans, das eine Alkenylgruppe aufweist, die an ein Siliciumatom gebunden ist;
(B) ein Polyorganohydrogensiloxan, das ein Wasserstoffatom aufweist, das in einer derartigen Menge an ein Siliciumatom gebunden ist, dass eine Menge des Wasserstoffatoms in der Komponente 0,1 bis 4,0 pro Alkenylgruppe in der (A)-Komponente wird;
(C) eine katalytische Menge eines Katalysators auf Platinbasis; und
(D) 0,05 bis 10 Masseteile des Haftvermögen verleihenden Mittels nach Anspruch 1 oder 2.

4. Adhäsive Polyorganosiloxanzusammensetzung nach Anspruch 3, wobei das Polyorganosiloxan, das die (A)-Komponente ist, eine trifunktionelle Siloxaneinheit umfasst, die eine Arylgruppe aufweist.

5. Adhäsive Polyorganosiloxanzusammensetzung nach Anspruch 4, wobei das (B)-Polyorganohydrogensiloxan in einer derartigen Menge compoundiert wird, dass eine Menge des Wasserstoffatoms in der Komponente 0,5 bis 2,5 pro Alkenylgruppe in der (A)-Komponente wird.

6. Adhäsive Polyorganosiloxanzusammensetzung nach Anspruch 4 oder 5, wobei die (A)-Komponente ein Polyorganosiloxan umfasst, das eine trifunktionelle Siloxaneinheit, enthält, die durch eine Formel: $C_6H_5SiO_{3/2}$ in einem Verhältnis von 20 bis 60 Mol-% mit Bezug auf alle konstitutionellen Einheiten dargestellt ist.

7. Adhäsive Polyorganosiloxanzusammensetzung nach einem der Ansprüche 4 bis 6, wobei die (A)-Komponente mindestens zwei Arten von Polyorganosiloxanen umfasst, die ein Polyorganosiloxan, das eine bifunktionelle Siloxaneinheit enthält, die durch eine Formel: $CH_3(CH_2{=}CH)SiO_{2/2}$ in einem Verhältnis von 10 Mol-% oder weniger mit Bezug auf alle konstitutionellen Einheiten dargestellt ist, und ein Polyorganosiloxan sind, das die bifunktionelle Siloxaneinheit enthält, die durch die Formel: $CH_3(CH_2{=}CH)SiO_{2/2}$ in einem Verhältnis von mehr als 10 Mol-% mit Bezug auf alle konstitutionellen Einheiten dargestellt ist.

8. Adhäsive Polyorganosiloxanzusammensetzung nach Anspruch 7, wobei die (A)-Komponente ein Polyorganosiloxan umfasst, das eine trifunktionelle Siloxaneinheit enthält, die durch eine Formel $C_6H_5SiO_{3/2}$ in einem Verhältnis von 30 bis 55 Mol-% mit Bezug auf alle konstitutionellen Einheiten dargestellt ist.

9. Adhäsive Polyorganosiloxanzusammensetzung nach einem der Ansprüche 4 bis 8, wobei die (B)-Komponente ein verzweigtes Polyorganohydrogensiloxan umfasst, das eine trifunktionelle Siloxaneinheit aufweist, die durch eine Formel: $C_6H_5SiO_{3/2}$ dargestellt ist.

10. Adhäsive Polyorganosiloxanzusammensetzung nach einem der Ansprüche 4 bis 9, wobei die (B)-Komponente ein Polyorganohydrogensiloxan umfasst, das Wasserstoffatome aufweist, die jeweils an Siliciumatome an beiden Molekülkettenterminalen gebunden sind.

11. Adhäsive Polyorganosiloxanzusammensetzung nach einem der Ansprüche 4 bis 10, ferner Folgendes umfassend: (E) 0,05 bis 5 Masseteile einer Isocyanatverbindung, die eine Alkoxygruppe aufweist.

12. Optische Halbleitervorrichtung umfassend ein ausgehärtetes Produkt, das durch Aushärten der adhäsiven Polyorganosiloxanzusammensetzung nach einem der Ansprüche 3 bis 11 hergestellt wird.

13. Optische Halbleitervorrichtung nach Anspruch 12, wobei das ausgehärtete Produkt einen Phosphor enthält.

## Revendications

1. Agent conférant de l'adhésivité, comprenant un polyorganosiloxane,

le polyorganosiloxane contenant :

(a) un motif siloxane trifonctionnel ayant un groupe époxy et représenté par une formule : $R^1SiO_{3/2}$, où $R^1$ représente un groupe époxyalkyle ou un groupe glycidoxyalkyle ;
(b) un motif siloxane bifonctionnel ayant un groupe alcényle représenté par une formule : $R^3{}_2SiO_{2/2}$, où $R^3$ représente un groupe hydrocarboné monovalent sélectionné parmi un groupe constitué d'un groupe alcényle et d'un groupe alkyle, et au moins un $R^3$ est un groupe alcényle ;

un motif siloxane trifonctionnel représenté par une formule $R^4SiO_{3/2}$, où $R^4$ représente un groupe alkyle ; et
un motif siloxane bifonctionnel représenté par une formule $R^4{}_2SiO_{2/2}$, où $R^4$ représente un groupe alkyle,
le polyorganosiloxane ayant un poids moléculaire moyen en poids de 1 000 à 15 000, ce poids moléculaire étant mesuré en utilisant un appareil de chromatographie par perméation sur gel (CPG) tel que décrit dans la description.

2. Agent conférant de l'adhésivité selon la revendication 1, dans lequel le (a) motif siloxane trifonctionnel ayant un groupe époxy présente un groupe glycidoxyalkyle lié à un atome de silicium.

3. Composition adhésive de polyorganosiloxane, comprenant :

(A) 100 parties en masse d'un polyorganosiloxane ayant un groupe alcényle lié à un atome de silicium ;
(B) un polyorganohydrogénosiloxane ayant un atome d'hydrogène lié à un atome de silicium en une quantité telle qu'une quantité de l'atome d'hydrogène dans le constituant devient de 0,1 à 4,0 par groupe alcényle dans le

constituant(A) ;
(C) une quantité catalytique d'un catalyseur à base de platine ; et
(D) de 0,05 à 10 parties en masse de l'agent conférant de l'adhésivité selon la revendication 1 ou 2.

**4.** Composition adhésive de polyorganosiloxane selon la revendication 3, dans laquelle le polyorganosiloxane étant le constituant (A) comprend un motif siloxane trifonctionnel ayant un groupe aryle.

**5.** Composition adhésive de polyorganosiloxane selon la revendication 4, dans laquelle le polyorganohydrogénosiloxane (B) est malaxé en une quantité telle qu'une quantité de l'atome d'hydrogène dans le constituant devient de 0,5 à 2,5 par groupe alcényle dans le constituant (A).

**6.** Composition adhésive de polyorganosiloxane selon la revendication 4 ou 5, dans laquelle le constituant (A) comprend un polyorganosiloxane contenant un motif siloxane trifonctionnel représenté par une formule : $C_6H_5SiO_{3/2}$ sous un rapport de 20 à 60 % en mole par rapport à tous les motifs constitutionnels.

**7.** Composition adhésive de polyorganosiloxane selon l'une quelconque des revendications 4 à 6, dans laquelle le constituant (A) comprend au moins deux types de polyorganosiloxanes qui sont un polyorganosiloxane contenant un motif siloxane bifonctionnel représenté par une formule : $CH_3(CH_2{=}CH)SiO_{2/2}$ sous un rapport de 10 % en mole ou moins par rapport à tous les motifs constitutifs, et un polyorganosiloxane contenant le motif siloxane bifonctionnel représenté par la formule : $CH_3(CH_2{=}CH)SiO_{2/2}$ sous un rapport de plus de 10 % en mole par rapport à tous les motifs constitutifs.

**8.** Composition adhésive de polyorganosiloxane selon la revendication 7, dans laquelle le constituant (A) comprend un polyorganosiloxane contenant un motif siloxane trifonctionnel représenté par une formule : $C_6H_5SiO_{3/2}$ sous un rapport de 30 à 55 % en mole par rapport à tous les motifs constitutionnels.

**9.** Composition adhésive de polyorganosiloxane selon l'une quelconque des revendications 4 à 8, dans laquelle le constituant (B) comprend un polyorganohydrogénosiloxane ramifié ayant un motif siloxane trifonctionnel représenté par une formule : $C_6H_5SiO_{3/2}$.

**10.** Composition adhésive de polyorganosiloxane selon l'une quelconque des revendications 4 à 9, dans laquelle le constituant (B) comprend un polyorganohydrogénosiloxane ayant des atomes d'hydrogène liés à des atomes de silicium respectivement aux deux terminaisons de la chaîne moléculaire.

**11.** Composition adhésive de polyorganosiloxane selon l'une quelconque des revendications 4 à 10, comprenant en outre :
(E) de 0,05 à 5 parties en masse d'un composé isocyanurate ayant un groupe alcoxy.

**12.** Dispositif semi-conducteur optique comprenant un produit durci fabriqué par durcissement de la composition adhésive de polyorganosiloxane selon l'une quelconque des revendications 3 à 11.

**13.** Dispositif semi-conducteur optique selon la revendication 12, dans lequel le produit durci contient une substance luminescente.

FIG. 1

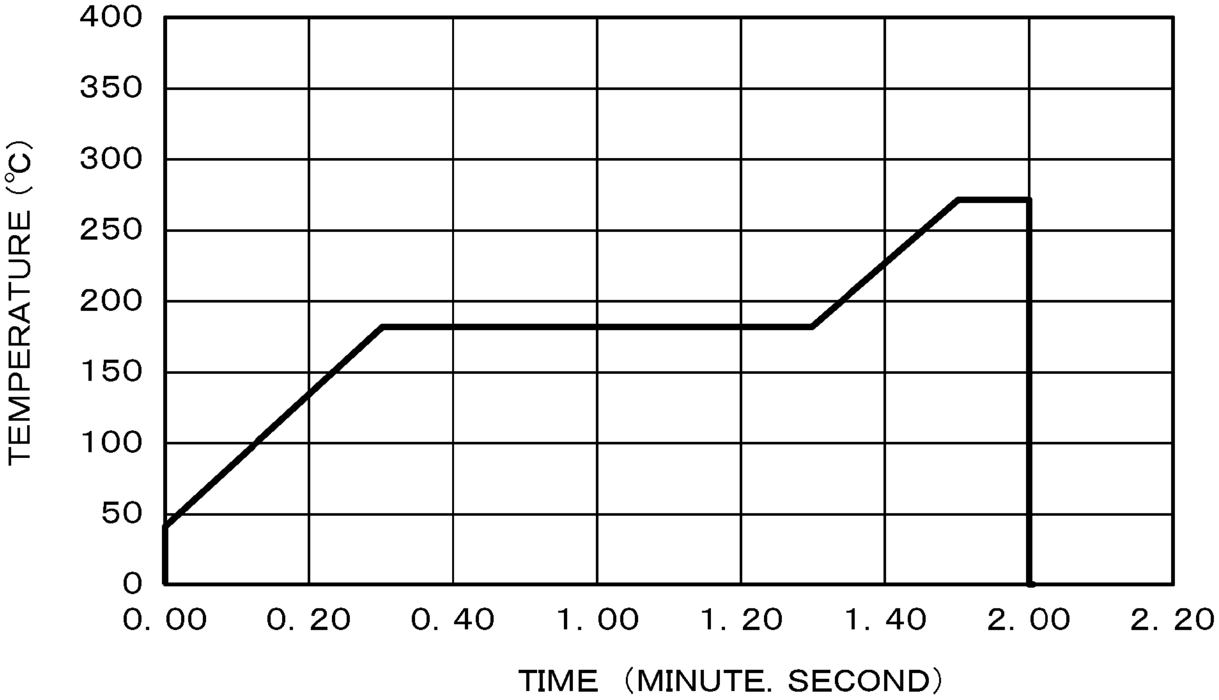
400
350
300
250
200
150
100
50
0
TEMPERATURE (°C)
0. 00
0. 20
0. 40
1. 00
1. 20
1. 40
2. 00
2. 20
TIME (MINUTE. SECOND)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010248384 A
- JP 2009269968 A
- JP H09310024 A